# EUROPEAN PATENT APPLICATION

(11) **EP 2 698 406 A1**
(43) Date of publication of application: **19.02.2014**
(21) Application number: 12770622.4
(22) Date of filing: 21.02.2012
(51) Int. Cl.: C09J 7/02, C09J 11/04, C09J 133/14, C09J 201/00

(54) **FLAME-RETARDANT HEAT-CONDUCTIVE ADHESIVE SHEET**

(30) Priority: 09.04.2011 JP 2011086866; 26.08.2011 JP 2011184256
(71) Applicant: Nitto Denko Corporation, Osaka 567-8680 (JP)
(72) Inventor: FURUTA, Kenji, Ibaraki-shi, Osaka 567-8680 (JP); TERADA, Yoshio, Ibaraki-shi, Osaka 567-8680 (JP); TOJO, Midori, Ibaraki-shi, Osaka 567-8680 (JP); NAKAMURA, Koichi, Ibaraki-shi, Osaka 567-8680 (JP)
(74) Representative: Grünecker, Kinkeldey, Stockmair & Schwanhäusser
(86) International application number: PCT/JP2012/054063
(87) International publication number: WO 2012/140955

(57) **Abstract**

A flame-retardant thermally-conductive pressure-sensitive adhesive sheet includes a substrate and a flame-retardant thermally-conductive pressure-sensitive adhesive layer provided on at least one surface of the substrate. The substrate includes a polyester film and the thickness of the polyester film is 10 to 40 µm, and the thermal resistance of the flame-retardant thermally-conductive pressure-sensitive adhesive sheet is 10 cm²·K/W or less.

## Description

### Technical Field

The present invention relates to a flame-retardant thermally-conductive pressure-sensitive adhesive sheet having both flame retardancy and thermally conductive properties.

### Background Art

By allowing an acrylic pressure-sensitive adhesive to contain a thermally conductive filler, conventionally, its thermally conductive properties have been improved as compared to those of a pressure-sensitive adhesive, which serves as a base. In the following Patent Document 1, for example, it has been disclosed that by using boron nitride particles each having a specific particle size and an acrylic polymer component, a high adhesive force (pressure-sensitive adhesive force) is capable of being imparted to a thermally-conductive pressure-sensitive adhesive sheet.

The thermally-conductive pressure-sensitive adhesive sheet has been widely used for uses of electronic components such as an encapsulation of a chip component or a formation of an insulating layer between a circuit mounted with a heat generating component and a heat dissipating board. The thermally-conductive pressure-sensitive adhesive sheet to be used is required to have high flame retardancy, in addition to adhesive properties such as thermally conductive properties, adhesive properties, and a holding force, in order to reduce the risk of ignition due to thermal runaway of a device.

In the following Patent Document 2, for example, a thermally-conductive flame-retardant pressure-sensitive adhesive and a pressure-sensitive adhesive tape having electrically insulating properties have been disclosed. They are characterized by containing 50 to 250 parts by mass of a hydrated metal compound having both functions of thermally conductive particles and a non-halogen-based flame retardant with respect to 100 parts by mass of an acrylic copolymer prepared from a monomer mixture containing 0.5 to 10 parts by mass of a polar vinyl monomer such as an acrylic acid as an essential component and 100 parts by mass of a pressure-sensitive adhesive composition composed of 10 to 100 parts by mass of a tackifier resin. In this invention, a tackifier is blended in order to compensate a reduction of the adhesive force caused by blending of a large amount of hydrated metal compound, but sufficient thermally conductive properties are not capable of being obtained.

Furthermore, in the following Patent Document 3, for example, as a thermally-conductive flame-retardant pressure-sensitive adhesive and a sheet having thermally conductive properties and flame retardancy, a thermally-conductive flame-retardant pressure-sensitive adhesive and a sheet containing an acrylic polymer, a flame retardant that has thermally conductive properties and does not contain a halogen, and a thermally conductive filler have been disclosed. In the following Patent Document 3, an example is described in which an aluminum hydroxide is used as a flame retardant and an aluminum oxide is used as a thermally conductive filler. It is also described that sufficient thermally conductive properties and flame retardancy are capable of being obtained even in a small filling amount by specifying the particle size thereof. However, both the thermally conductive properties and the flame retardancy are not satisfactory.

As disclosed in the following Patent Documents 1 to 3, in order to satisfy the thermally conductive properties and the flame retardancy, blending of a large amount of thermally conductive particles and flame retardant has been considered. However, there is a problem that the preparation of a pressure-sensitive adhesive sheet becomes difficult by losing fluidity of a pressure-sensitive adhesive composition (a viscous liquid), and a pressure-sensitive adhesive layer is hardened, so that the adhesive performance is reduced.

When the flexible thermally conductive pressure-sensitive adhesive sheet is attempted to follow an adherend in a particular shape such as an uneven surface or a curved surface and is attempted to be bonded thereto, there is a problem in processability such as occurrence of a wrinkle, a tear, or elongation in the thermally conductive pressure-sensitive adhesive sheet. In order to solve the problem, retaining the thermally conductive pressure-sensitive adhesive sheet by, for example, a substrate made of a plastic film has been performed (for example, the following Patent Document 4). The plastic film itself, however, is flammable in many cases and it has been difficult to satisfy the flame retardancy of UL94 V-0 standard.

### Prior Art Document

### Patent Document

Patent Document 1: Japanese Unexamined Patent Publication No. 2010-174173
Patent Document 2: Japanese Unexamined Patent Publication No. H 11-269438
Patent Document 3: Japanese Unexamined Patent Publication No. 2002-294192
Patent Document 4: Japanese Unexamined Patent Publication No. 2001-168246

### Summary of the Invention

### Problems to be solved by the Invention

It is an object of the present invention to provide a flame-retardant thermally-conductive pressure-sensitive adhesive sheet having excellent thermally conductive properties and flame retardancy and having excellent bonding properties to an adherend.

### Solution to the Problems

The inventors of the present invention have earnestly considered in order to achieve the above-described object and as a result, completed a flame-retardant thermally-conductive pressure-sensitive adhesive sheet having both excellent bonding properties and flame retardancy without damaging the thermally conductive properties by using a polyester film having a specified thickness as a substrate. That is, when the workability (attaching properties) of the flame-retardant thermally-conductive pressure-sensitive adhesive sheet is improved, providing a thick substrate is considered. When the flame retardancy and the thermally conductive properties of the substrate itself are poor, however, thickening of the substrate leads to a reduction in the flame retardancy and the thermally conductive properties. On the other hand, when the substrate is thin, improvement in the flame retardancy and the thermally conductive properties is expected. When a polyester film is used as the substrate, however, in a case where the thickness of the substrate is thinner than a certain thickness, an adverse phenomenon of a reduction in the flame retardancy is unexpectedly confirmed. This phenomenon is considered to be caused because due to the thin polyester film, the rate of melting and burning is higher than the extinction rate of the flame-retardant thermally-conductive pressure-sensitive adhesive sheet that is ignited. That is, the inventors of the present invention have found that in the case of the flame-retardant thermally-conductive pressure-sensitive adhesive sheet using a polyester film as a substrate, the flame retardancy and the thermally conductive properties are capable of being simultaneously satisfied within a specified thickness range and have completed the present invention.

That is, the present invention provides a flame-retardant thermally-conductive pressure-sensitive adhesive sheet including a substrate and a flame-retardant thermally-conductive pressure-sensitive adhesive layer provided on at least one surface of the substrate, wherein the substrate includes a polyester film and the thickness of the polyester film is 10 to 40 µm, and the thermal resistance is 10 cm²·K/W or less.

In the flame-retardant thermally-conductive pressure-sensitive adhesive sheet of the present invention, it is preferable that the flame-retardant thermally-conductive pressure-sensitive adhesive layer does not substantially contain a halogen-based flame-retardant component and it is preferable that the thickness of the flame-retardant thermally-conductive pressure-sensitive adhesive layer is 10 to 250 µm.

In the flame-retardant thermally-conductive pressure-sensitive adhesive sheet of the present invention, it is preferable that the flame-retardant thermally-conductive pressure-sensitive adhesive layer contains 100 parts by weight of (a) an acrylic polymer and 100 to 500 parts by weight of (b) a hydrated metal compound and it is preferable that the (a) an acrylic polymer contains, as a polar group-containing monomer, a nitrogen-containing monomer and/or a hydroxyl group-containing monomer as a component.

Furthermore, in the flame-retardant thermally-conductive pressure-sensitive adhesive sheet of the present invention, it is preferable that in the (b) a hydrated metal compound, a particle having a primary average particle size of 5 µm or more and a particle having a primary average particle size of less than 5 µm are contained at a ratio of 1:10 to 10:1 (ratio by weight).

In the flame-retardant thermally-conductive pressure-sensitive adhesive sheet of the present invention, it is preferable that the tensile elastic modulus is 10 to 600 MPa.

### Effect of the Invention

According to the flame-retardant thermally-conductive pressure-sensitive adhesive sheet of the present invention, a flame-retardant thermally-conductive pressure-sensitive adhesive sheet having excellent thermally conductive properties and flame retardancy and having excellent bonding properties to an adherend can be provided. Such a flame-retardant thermally-conductive pressure-sensitive adhesive sheet uses its properties and is favorably used in uses such as a hard disk, an LED lighting, or a lithium ion battery.

### Brief Description of the Drawings

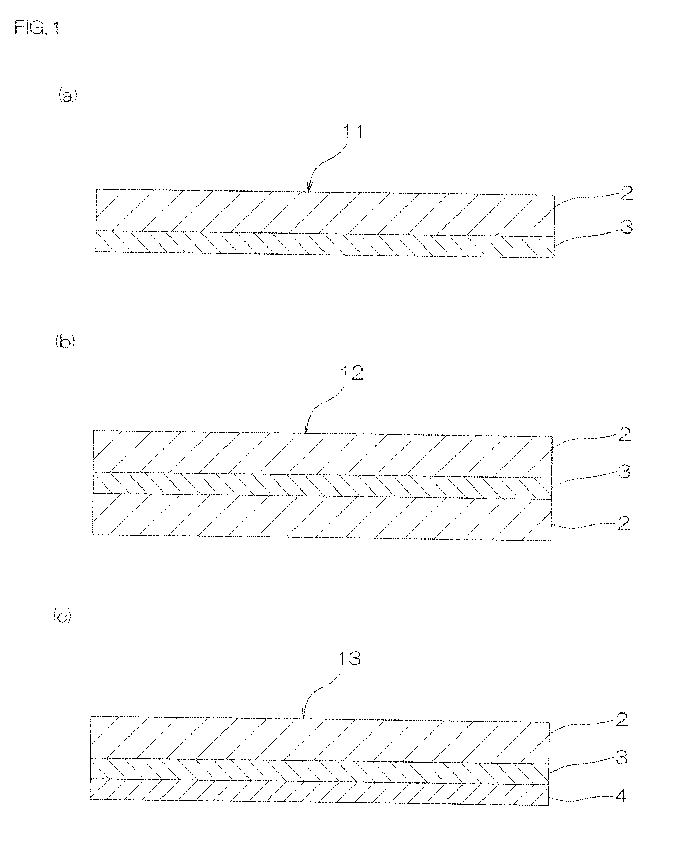

[FIG. 1] FIG. 1 shows schematic sectional views for partially illustrating an example of a flame-retardant thermally-conductive pressure-sensitive adhesive sheet of the present invention:
   (a) illustrating a configuration of forming a flame-retardant thermally-conductive pressure-sensitive adhesive layer on one surface of a substrate,
   (b) illustrating a configuration of forming the flame-retardant thermally-conductive pressure-sensitive adhesive layers on both surfaces of the substrate, and
   (c) illustrating a configuration of forming the flame-retardant thermally-conductive pressure-sensitive adhesive layer on one surface of the substrate and forming a non-flame retardant thermally-conductive pressure-sensitive adhesive layer on the other surface thereof.

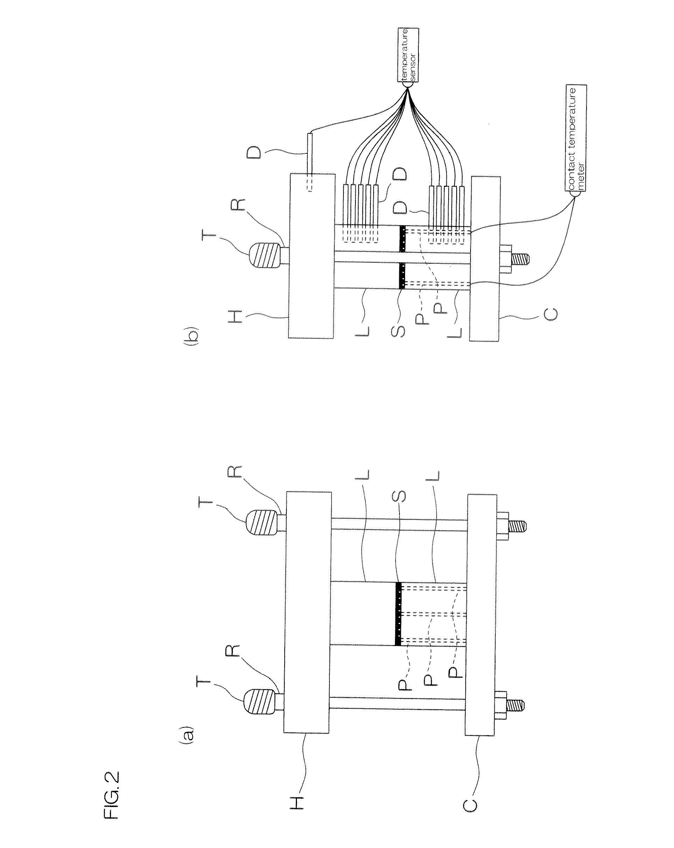

[FIG. 2] FIG. 2 shows explanatory views of a thermal property evaluation apparatus measuring the thermal conductivity and the thermal resistance in Examples:
   (a) illustrating a front view and
   (b) illustrating a side view.

### Embodiment of the Invention

### (Flame-Retardant Thermally-Conductive Pressure-Sensitive Adhesive Sheet)

A flame-retardant thermally-conductive pressure-sensitive adhesive sheet of the present invention includes a substrate and a flame-retardant thermally conductive pressure-sensitive adhesive layer provided on at least one surface of the substrate, wherein the substrate includes a polyester film and the thickness of the polyester film is 10 to 40 µm, and the thermal resistance is 10 cm²·K/W or less.

The flame-retardant thermally-conductive pressure-sensitive adhesive sheet of the present invention is described with reference to figures. The flame-retardant thermally-conductive pressure-sensitive adhesive sheet of the present invention includes the flame-retardant thermally-conductive pressure-sensitive adhesive layer on at least one surface of the substrate including the polyester film. The flame-retardant thermally-conductive pressure-sensitive adhesive sheet may have a form in which both surfaces thereof serve as adhesive surfaces (pressure-sensitive adhesive surfaces) or may have a form in which one surface thereof only serves as an adhesive surface. To be specific, examples of the form of the flame-retardant thermally-conductive pressure-sensitive adhesive sheet include as shown in FIG. 1 (a), a form in which one surface of a substrate is formed of the flame-retardant thermally-conductive pressure-sensitive adhesive layer and serves as an adhesive surface and as shown in FIGS. 1 (b) or (c), a form in which at least one surface of a substrate is formed of the flame-retardant thermally-conductive pressure-sensitive adhesive layer and the opposite surface of the substrate is formed of a pressure-sensitive adhesive layer, and both surfaces thereof serve as adhesive surfaces. In the present invention, the "sheet" is used as a concept including a shape such as "tape", "sheet", and "film". The shape in accordance with its intended purpose may be subjected to a punching process or a cutting process.

FIG. 1 shows schematic sectional views for partially illustrating an example of a flame-retardant thermally-conductive pressure-sensitive adhesive sheet of the present invention. In FIG. 1, 11, 12, and 13 represent a flame-retardant thermally-conductive pressure-sensitive adhesive sheet provided with a flame-retardant thermally-conductive pressure-sensitive adhesive layer on at least one surface of a substrate including a polyester film, respectively; 2 represents a flame-retardant thermally-conductive pressure-sensitive adhesive layer; 3 represents a substrate; and 4 represents a pressure-sensitive adhesive layer (a non-flame retardant thermally-conductive pressure-sensitive adhesive layer). A flame-retardant thermally-conductive pressure-sensitive adhesive sheet 11 shown in FIG. 1 (a) has a structure in which a flame-retardant thermally-conductive pressure-sensitive adhesive layer 2 is provided on one surface of a substrate 3. A flame-retardant thermally-conductive pressure-sensitive adhesive sheet 12 shown in FIG. 1 (b) has a structure in which the flame-retardant thermally-conductive pressure-sensitive adhesive layers 2 are provided on both surfaces of the substrate 3. A flame-retardant thermally-conductive pressure-sensitive adhesive sheet 13 shown in FIG. 1 (c) has a structure in which the flame-retardant thermally-conductive pressure-sensitive adhesive layer 2 is formed on one surface of the substrate 3 and a pressure-sensitive adhesive layer (a non-flame retardant thermally-conductive pressure-sensitive adhesive layer) 4 is formed on the other surface thereof.

In the case of the structure in which the flame-retardant thermally-conductive pressure-sensitive adhesive layer 2 is formed on one surface of the substrate 3 shown in FIG. 1 (a), a treated layer for preventing a stain or a flaw may be formed on the other surface on which the flame-retardant thermally-conductive pressure-sensitive adhesive layer 2 is not formed of the substrate 3. As the treated layer for preventing a statin, in order to make a stain hardly adhere, for example, a treated layer obtained by processing the surface of a substrate with silicone, fluorine, or the like having a low surface tension can be used. The surface tension is not particularly limited and is preferably 50 dyne/cm or less, more preferably 40 dyne/cm or less, or further more preferably 30 dyne/cm or less. As the treated layer for preventing a flaw, for example, a hard coat layer having a high pencil hardness can be formed. The pencil hardness thereof is, for example, H or more, preferably 2 H or more, or more preferably 3 H or more.

The flame-retardant thermally-conductive pressure-sensitive adhesive sheet of the present invention may be formed in a form of being wound in a roll shape or in a form of sheets being laminated. When the flame-retardant thermally-conductive pressure-sensitive adhesive sheet has a form of being wound in a roll shape or is laminated, the flame-retardant thermally-conductive pressure-sensitive adhesive layers can be prevented from being directly in contact with each other by a release liner.

The thickness (the total thickness) of the flame-retardant thermally-conductive pressure-sensitive adhesive sheet of the present invention is preferably 10 to 1000 µm, or more preferably 50 to 500 µm. When the thickness of the flame-retardant thermally-conductive pressure-sensitive adhesive sheet is less than 10 µm, there is a disadvantage that it is above the average particle size of the filler, so that a film is not capable of being produced. On the other hand, when the thickness of the flame-retardant thermally-conductive pressure-sensitive adhesive sheet is above 1000 µm, there is a disadvantage that it is difficult to set the heat resistance to be 10 cm²·K/W or less. In the present invention, the thickness (the total thickness) of the flame-retardant thermally-conductive pressure-sensitive adhesive sheet is the sum total of the thickness of the substrate and the flame-retardant thermally-conductive pressure-sensitive adhesive layer that constitute the flame-retardant thermally-conductive pressure-sensitive adhesive sheet and does not include, for example, the thickness of a release liner to be described later.

Preferably, in view of environmental protection, the flame-retardant thermally-conductive pressure-sensitive adhesive sheet of the present invention does not substantially contain a halogen-based flame retardant component. That is, preferably, in both the substrate and the flame-retardant thermally-conductive pressure-sensitive adhesive layer that constitute the flame-retardant thermally-conductive pressure-sensitive adhesive sheet of the present invention, the halogen-based flame retardant component is not substantially contained as the component. In the present invention, the term of "not substantially containing a halogen-based flame-retardant component" refers to a case where the halogen-based flame-retardant component is not used at all or a case where an amount of the halogen-based flame-retardant component is a detection limit or less in an evaluation method that is generally used.

### (Substrate)

In the present invention, the substrate is characterized by including a polyester film. Examples of the polyester film that is capable of being used in the present invention include a polyethylene terephthalate (PET), polyethylene naphthalate (PEN), and polybutylene terephthalate (PBT). These materials can be used alone or in combination of two or more. By using the polyester film as the substrate, there is an advantage that it has, for example, a higher breaking strength, a higher Young's modulus, and a higher dielectric breakdown voltage than those of the substrate such as a polyolefin film, a polyamide film, or a polyimide film.

In the present invention, the thickness of the polyester film is 10 to 40 µm, preferably 11 to 39 µm, or more preferably 12 to 38 µm. When the thickness of the polyester film is within the above-described range, the flame retardancy that satisfies a flame retardant standard of UL94 V-0 is capable of being obtained. On the other hand, when the thickness of the polyester film is less than 10 µm or above 40 µm, the flame retardant standard of UL94 V-0 is not capable of being satisfied.

That is, when the thickness of the polyester film is less than 10 µm, the flame retardant standard of UL94 V-0 is not capable of being satisfied due to the phenomenon of dripping of a tape during burning. When the thickness of the polyester film is above 40 µm, the flame retardant standard of UL94 V-0 is not capable of being satisfied because the polyester film burns.

In the flame-retardant thermally-conductive pressure-sensitive adhesive sheet of the present invention, the ratio of the thickness of the polyester film to the thickness of the flame-retardant thermally-conductive pressure-sensitive adhesive layer (the total thickness of the pressure-sensitive adhesive layers) to be described later is preferably 1:1 to 1:50, or more preferably 1:2 to 1:40. When the ratio of the thickness of the flame-retardant thermally-conductive pressure-sensitive adhesive layer to that of the polyester film is above 50, the thermally conductive properties may be damaged. When the ratio of the thickness of the flame-retardant thermally-conductive pressure-sensitive adhesive layer to that of the polyester film is less than 1, the handling ability of the tape may be worsened.

In the present invention, the substrate may be a single piece of polyester film. Also, the substrate may have a form of being laminated with another substrate as long as it does not damage the effect of the present invention. An example of the substrate includes an appropriate thin leaf body such as a paper-based substrate including paper; a fiber-based substrate including cloth, non-woven fabric, or a net; a metal-based substrate including a metal foil or a metal plate; a plastic substrate including a plastic film or sheet; a rubber-based substrate including a rubber sheet; and a foaming material including a foaming sheet or a laminate thereof (in particular, a laminate of a plastic substrate with another substrate, a laminate of plastic films (or sheets) with each other, or the like). Examples of a material used in a plastic film or sheet include an olefin-based resin having an α-olefin as a monomer component such as polyethylene (PE), polypropylene (PP), an ethylene-propylene copolymer, and an ethylene-vinyl acetate copolymer (EVA); polyvinyl chloride (PVC); a vinyl acetate-based resin; polyphenylene sulfide (PPS); an amide-based resin such as polyamide (nylon) and wholly aromatic polyamide (aramid); a polyimide resin; and polyether ether ketone (PEEK). These materials can be used alone or in combination of two or more and their laminate form is not particularly limited.

In the present invention, when another film and a resin layer are laminated on the polyester film to serve as the substrate, desirably, the whole thickness of the substrate is 11 to 100 µm, or preferably 12 to 40 µm. When the whole thickness of the substrate is less than 11 µm, there may be a case where the thermally conductive properties are improved and the handling ability is reduced. On the other hand, when the whole thickness of the substrate is above 40 µm, there may be a case where the handling ability is improved and the thermally conductive properties are reduced.

In order to increase the adhesiveness to the flame-retardant thermally-conductive pressure-sensitive adhesive layer or the like, the surface of the substrate may be subjected to conventional surface treatment such as oxidation treatment by a chemical or physical method such as corona treatment, chromic acid treatment, ozone exposure, flame exposure, high-pressure shock exposure, and ionized radiation treatment, or may be subjected to coating treatment by a primer, a release agent, or the like.

In the present invention, the thermal resistance of the flame-retardant thermally-conductive pressure-sensitive adhesive sheet is 10 cm²·K/W or less, preferably 6 cm²·K/W or less, or more preferably 4 cm²·K/W or less. When the thermal resistance of the flame-retardant thermally-conductive pressure-sensitive adhesive sheet is above 10 cm²·K/W or less, the function thereof as a thermally conductive sheet is not capable of being sufficiently developed.

The flame retardancy of the flame-retardant thermally-conductive pressure-sensitive adhesive sheet of the present invention is required to satisfy UL94 V-0 standard. When UL94 V-0 standard is satisfied, there is an advantage that vertical burning is capable of being suppressed at the time of ignition, so that the flame-retardant thermally-conductive pressure-sensitive adhesive sheet can be used as, for example, a thermally conductive member of an electronic device.

### (Flame-Retardant Thermally-Conductive Pressure-Sensitive Adhesive Layer)

The flame-retardant thermally-conductive pressure-sensitive adhesive layer used in the flame-retardant thermally-conductive pressure-sensitive adhesive sheet of the present invention is not particularly limited and a conventionally known flame-retardant thermally-conductive pressure-sensitive adhesive layer can be used. The flame-retardant thermally-conductive pressure-sensitive adhesive layer in the present invention refers to having a function of UL94 V-2, preferably V-1, or more preferably V-0. In view of capable of easily achieving both the thermally conductive properties and the flame retardancy and having excellent pressure-sensitive adhesive properties such as an adhesive force and a holding force, preferably, an acrylic pressure-sensitive adhesive layer containing an acrylic polymer as a main component is used. In order to set the thermal resistance of the flame-retardant thermally-conductive pressure-sensitive adhesive sheet to be 10 cm²·K/W or less and to obtain the flame retardancy satisfying UL94 V-0 standard, in particular, preferably, the flame-retardant thermally-conductive pressure-sensitive adhesive layer containing the (b) a hydrated metal compound in the (a) an acrylic polymer is used.

### (Acrylic Polymer)

In the present invention, as the (a) an acrylic polymer constituting the flame-retardant thermally-conductive pressure-sensitive adhesive layer, an acrylic polymer prepared by copolymerizing a monomer component containing an alkyl (meth)acrylate as a main component and containing a polar group-containing monomer is used. These acrylic polymers can be used alone or in combination of two or more.

An example of the alkyl (meth)acrylate constituting the acrylic polymer includes a C₁₋₂₀ alkyl (meth)acrylate such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate.

In view of keeping well-balanced adhesive properties, in particular, preferably, a C₂₋₁₂ alkyl (meth)acrytate can be used, or more preferably, a C₄₋₉ alkyl (meth)acrylate can be used.

The above-described alkyl (meth)acrylate is used as the main component in the monomer component constituting the acrylic polymer. It is important that the ratio of the alkyl (meth)acrylate with respect to the total amount of the monomer component for preparing the acrylic polymer is, for example, 60 weight % or more (for example, 60 to 99 weight %), or preferably 80 weight % or more (for example, 80 to 98 weight %).

Preferably, the (a) an acrylic polymer in the present invention, contains, as a monomer component, 5 weight % or more of the polar group-containing monomer in the monomer component. By containing 5 weight % or more of the polar group-containing monomer in the monomer component, for example, the adhesive force to the adherend can be improved or the cohesive force of the flame-retardant thermally-conductive pressure-sensitive adhesive layer can be increased.

In the present invention, preferably, a carboxyl group-containing monomer is not substantially contained as a monomer component. The term "a carboxyl group-containing monomer" is defined as a monomer having, in a molecule, one or more carboxyl group(s) (can be in a state of anhydride). Examples thereof include a (meth)acrylic acid, an itaconic acid, a maleic acid, a fumaric acid, a crotonic acid, an isocrotonic acid, a maleic anhydride, and an itaconic anhydride. The term of a monomer component "not substantially containing" a carboxyl group-containing monomer is defined that a monomer component does not contain a carboxyl group-containing monomer at all or the content thereof with respect to the monomer component is 0.1 weight % or less.

That is, in the present invention, when a carboxyl group-containing monomer is contained in an acrylic polymer, a reduction in the adhesive properties tends to occur. Or, when it is blended with a hydrated metal compound to be described later, there may be a case where the fluidity of a pressure-sensitive adhesive composition is reduced and the preparation of a pressure-sensitive adhesive sheet becomes difficult. These causes are not sufficiently clarified. It is considered that the effect of improving the adhesive force of the carboxyl group-containing monomer as a polar group is not capable of being developed because a functional group (for example, a hydroxyl group) contained in the hydrated metal compound is reacted with a carboxyl group, so that the acrylic polymer and the hydrated metal compound are brought into a state of being bonded to each other. Also, it is considered that the acrylic polymer is brought into a pseudo cross-linked state (that is, is hardened), so that the fluidity is reduced and the adhesive properties are reduced due to a reduction in the wettability. Thus, there is no problem that the carboxyl group-containing monomer is contained in a minimal amount. However, when the carboxyl group-containing monomer is substantially contained, a large amount of hydrated metal compound is not capable of being contained. Thus, there may be a case where the object of the present invention of providing a flame-retardant thermally-conductive pressure-sensitive adhesive sheet having excellent thermally conductive properties and flame retardancy and having excellent bonding properties to an adherend cannot be achieved.

Examples of the polar group-containing monomer include a nitrogen-containing monomer, a hydroxyl group-containing monomer, a sulfonic acid group-contaning monomer, and a phosphoric acid group-containing monomer These polar group-containing monomers can be used alone or in combination of two or more In the present invention, in view of obtaining high adhesive properties and a high holding force, preferably, a nitrogen-containing monomer and a hydroxyl group-containing monomer can be used

In the present invention, examples of the hydroxyl group-containing monomer include a 2-hydroxyethyl (meth)acrylate, a 3-hydroxypropyl (meth)acrylate, a 4-hydroxybutyl (meth)acrylate, a 6-hydroxyhexyl (meth)acrylate, an 8-hydroxyoctyl (meth)acrylate, a 10-hydroxydecyl (meth)acrylate, a 12-hydroxylauryl (meth)acrylate, and a (4-hydroxymethylcyclohexyl) methyl methacrylate Of the hydroxyl group-containing monomers, in view of excellent wettability to an adherend, preferably, a hydroxyethyl (meth)acrylate and a hydroxybutyl (meth)acrylate can be used

In the present invention, examples of the nitrogen-containing monomer include an N-hydroxyalkyl (meth)acrylamide such as N-(2-hydroxyethyl) (meth)acrylamide (HEAA), N-(2-hydroxypropyl) (meth)acrylamide, N-(1-hydroxypropyl) (meth)acrylamide, N-(3-hydroxypropyl) (meth)acrylamide, N-(2-hydroxybutyl) (meth)acrylamide, N-(3-hydroxybutyl) (meth)acrylamide, and N-(4-hydroxybutyl) (meth)acrylamide, a cyclic (meth)acrylamide such as N-(meth)acryloylmorpholine and N-acryloylpyrrolidine, an cyclic (meth)acrylamide such as (meth)acrylamide and N-substituted (meth)acrylamide (for example, N-alkyl (meth)acrylamide such as N-ethyl (meth)acrylamide and N-n-butyl (meth)acrylamide and N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, N,N-di(n-butyl) (meth)acrylamide, and N,N-di(t-butyl) (meth)acrylamide); an N-vinyl cyclic amide such as N-vinyl-2-pyrrolidone (NVP), N-vinyl-2-piperidone, N-vinil-3-morpholinone, N-vinyl-2-caprolactam, N-vinyl-1,3-oxazine-2-one, and N-vinyl-3,5-morpholinedione, an amino group-containing monomer such as aminoethyl (meth)acrylate, N,N-dimethylaminoethyl (meth)acrylate, and N,N-dimethylaminopropyl (meth)acrylate; a maleimide skeleton-containing monomer such as N-cyclohexylmaleimide and N-phenylmaleimide, and an itaconimide-based monomer such as N-methylitaconimide, N-ethylitaconimide, N-butylitaconimide, N-2-ethylhexylitaconimide, N-laurylitaconimide, and N-cyclohexylitaconimide.

Of the nitrogen-containing monomers, in view of excellent adhesive properties at the time of initial bonding, preferably, N-vinyl-2-pyrrolidone, N-(meth)acryloylmorpholine, and N,N-diethyl (meth)acrylamide can be used.

In the present invention, examples of the sulfonic acid group-containing monomer include a styrene sulfonic acid, an allyl sulfonic acid, a 2-(meth)acrylamide-2-methylpropanesulfonic acid, a (meth)acrylamide propanesulfonic acid, a sulfopropyl (meth)acrylate, and a (meth)acryloyloxy naphthalene sulfonic acid.

In the present invention, an example of the phosphoric acid group-containing monomer includes a 2-hydroxyethyl acryloyl phosphate.

In the present invention, desirably, the mixing ratio of the polar group-containing monomer with respect to the total amount of the monomer component for preparing the acrylic polymer is 5 weight % or more, for example, 5 to 30 weight %, or preferably 6 to 25 weight %. When the used amount of the polar group-containing monomer is 5 weight % or more, an excellent holding force is capable of being obtained. On the other hand, when the used amount of the polar group-containing monomer is less than 5 weight %, there may be a case where a cohesive force of the flame-retardant thermally-conductive pressure-sensitive adhesive layer is reduced and a high holding force is not capable of being obtained. On the other hand, when the used amount of the polar group-containing monomer is above 30 weight %, there may be a case where the cohesive force of the flame-retardant thermally-conductive pressure-sensitive adhesive layer is excessively increased, so that the adhesive properties are reduced.

In the present invention, a polyfunctional monomer can be used as a monomer component as required. By using the polyfunctional monomer, a cross-linking structure can be introduced into the acrylic polymer, so that the cohesive force required as the flame-retardant thermally-conductive pressure-sensitive adhesive layer can be adjusted.

Examples of the polyfunctional monomer include a hexanediol (meth)acrylate, a (poly)ethylene glycol di(meth)acrylate, a (poly)propylene glycol di(meth)acrylate, a neopentyl glycol di(meth)acrylate, a pentaerythritol di(meth)acrylate, a pentaerythritol tri(meth)acrylate, a dipentaerythritol hexa(meth)acrylate, a trimethylolpropane tri(meth)acrylate, a tetramethylolmethane tri(meth)acrylate, an allyl (meth)acrytate, a vinyl (meth)acrylate, a divinylbenzene, an epoxy acrylate, a polyester acrylate, a urethane acrylate, a dibutyl (meth)acrylate, and a hexydyl (meth)acrylate. These polyfunctional monomers can be used alone or in combination of two or more.

In the present invention, preferably, the mixing ratio of the polyfunctional monomer with respect to the total amount of the monomer component for preparing the acrylic polymer is 2 weight % or less, for example, 0.01 to 2 weight %, or more preferably 0.02 to 1 weight %. When the used amount of the polyfunctional monomer with respect to the total amount of the monomer component for preparing the acrylic polymer is above 2 weight %, there may be a case where the cohesive force of the flame-retardant thermally-conductive pressure-sensitive adhesive layer is excessively increased, so that the adhesive properties are reduced. When the used amount of the polyfunctional monomer with respect to the total amount of the monomer component for preparing the acrylic polymer is less than 0.01 weight %, the cohesive force of the flame-retardant thermally-conductive pressure-sensitive adhesive layer may be reduced.

As the (a) an acrylic polymer in the present invention, another monomer can be also used as the monomer component as required. By using another monomer, for example, various properties of the pressure-sensitive adhesive and the structure of the acrylic polymer are capable of being further appropriately controlled.

Examples of another monomer capable of being used in the present invention include an epoxy group-containing monomer such as glycidyl (meth)acrylate and allyl glycidyl ether, an alkoxy group-containing monomer such as 2-methoxyethyl (meth)acrylate, 3-methoxypropyl (meth)acrylate, methoxyethylene glycol (meth)acrylate, and methoxypolypropylene glycol (meth)acrylate, a cyano group-containing monomer such as acrylonitrile and methacrylonitrile, a styrene-based monomer such as styrene and α-methylstyrene, an α-olefin such as ethylene, propylene, isoprene, butadiene, and isobutylene, an isocyanate group-containing monomer such as 2-isocyanate ethyl acrylate and 2-isocyanate ethyl methacrylate, a vinyl ester-based monomer such as vinyl acetate and vinyl propionate; a vinyl ether-based monomer such as vinyl ether, heterocycle-containing (meth)acrylate ester such as tetrahydroflufuryl (meth)acrylate; a halogen atom-containing monomer such as fluorine (meth)acrylate; an alkoxysilyl group-containing monomer such as 3-methacryloxypropyl trimethoxysilane and vinyltrimethoxysilane, a siloxane bond-containing monomer such as silicone (meth)acrylate; alkyl (meth)acrylate containing an alkyl group having 21 or more hydrocarbon atoms; an alicyclic hydrocarbon group-containing (meth)acrylate such as cyclopentyl (meth)acrylate, cyclohexyl (meth)acrylate, bornyl (meth)acrylate, and isobornyl (meth)acrylate; and an aromatic hydrocarbon group-containing (meth)acrylate such as phenyl (meth)acrylate, benzyl (meth)acrylate, phenoxyethyl (meth)acrylate, and phenoxydiethylene glycol (meth)acrylate These other monomers can be used alone or in combination of two or more

In the present invention, of the monomers, preferably, an alkoxy group-containing monomer is used, or particularly preferably, 2-methoxyethyl acrylate is used By using the alkoxy group-containing monomers in combination, the wettability of the flame-retardant thermally-conductive pressure-sensitive adhesive layer can be improved and heat from an adherend (a source of heat) can be efficiently conducted

In the present invention, appropriately, the mixing ratio of another monomer with respect to the total amount of the monomer component for preparing the acrylic polymer is 30 weight % or less, or preferably 20 weight % or less. The monomer component that does not substantially contain another monomer may be also used. When the alkoxy group-containing monomer is used, the mixing ratio thereof with respect to the total amount of the monomer component for preparing the acrylic polymer can be 5 weight % or more (for example, 5 to 20 weight %), or preferably 8 weight % or more (for example, 8 to 15 weight %).

In the present invention, desirably, the (a) an acrylic polymer has a glass transition temperature (Tg) of about -10°C or less (typically, about -10°C to -70°C), or preferably -20°C or less (typically, about -20°C to -70°C). That is, preferably, the composition and the mixing amount of the monomer component are adjusted so that the Tg of the acrylic polymer obtained by polymerizing the monomer component is within the above-described range. The Tg of the acrylic polymer refers to a value obtained by the formula of Fox based on the Tg of a homopolymer of each of the monomers constituting the monomer component and the weight fraction (copolymer composition) of the monomer. The value of the Tg of the homopolymer can be obtained by various known materials ("Handbook of Pressure-Sensitive Adhesive Technology" from NIKKAN KOGYO SHINBUN, LTD. or the like).

In the present invention, in the preparation of the acrylic polymer, the acrylic polymer can be obtained by copolymerizing the monomer component. The method for copolymerization is not particularly limited and a curing reaction by heat or an ultraviolet ray using a polymerization initiator such as a thermal polymerization initiator and a photopolymerization initiator (a photoinitiator) can be used.

As the polymerization initiator, in view of advantages of being capable of shortening a polymerization duration, preferably, a photopolymerization initiator can be used. That is, preferably, using the polymerization in which the ultraviolet ray is used, the monomer component is copolymerized, so that the acrylic polymer is obtained. These polymerization initiators can be used alone or in combination of two or more.

The polymerization initiator is not particularly limited and examples thereof can include a benzoin ether-based photopolymerization initiator, an acetophenone-based photopolymerization initiator, an α-ketol-based photopolymerization initiator, an aromatic sulfonyl chloride-based photopolymerization initiator, a photo active oxime-based photopolymerization initiator, a benzoin-based photopolymerization initiator, a benzyl-based photopolymerization initiator, a benzophenone-based photopolymerization initiator, a ketal-based photopolymerization initiator, and a thioxanthone-based photopolymerization initiator.

To be specific, examples of the benzoin ether-based photopolymerization initiator include benzoin methyl ether, benzoin ethyl ether, benzoin propyl ether, benzoin isopropyl ether, benzoin isobutyl ether, 2,2-dimethoxy-1,2-diphenylethane-1-one, and anisole methyl ether. Examples of the acetophenone-based photopolymerization initiator include 2,2-diethoxyacetophenone, 2,2-dimethoxy-2-phenylacetophenone, 1-hydroxycyclohexyl phenyl ketone, 4-phenoxydichloroacetophenone, and 4-(t-butyl)dichloroacetophenone. Examples of the α-ketol-based photopolymerization initiator include 2-methyl-2-hydroxypropiophenone and 1-[4-(2-hydroxyethyl)phenyl]-2-methylpropane-1-one. An example of the aromatic sulfonyl chloride-based photopolymerization initiator includes 2-naphthalenesulfonylchloride. An example of the photo active oxime-based photopolymerization initiator includes 1-phenyl-1,1-propanedione-2-(o-ethoxycarbonyl)-oxime.

An example of the benzoin-based photopolymerization initiator includes benzoin. An example of the benzyl-based photopolymerization initiator includes benzyl. Examples of the benzophenone-based photopolymerization initiator include benzophenone, benzoylbenzoic acid, 3,3'-dimethyl-4-methoxybenzophenone, polyvinylbenzophenone, and α-hydroxycyclohexyl phenyl ketone. Examples of the ketal-based photopolymerization initiator include thioxanthone, 2-chlorothioxanthone, 2-methylthioxanthone, 2,4-dimethylthioxanthone, isopropylthioxanthone, 2,4-diisopropylthioxanthone, and decylthioxanthone.

The used amount of the photopolymerization initiator is not particularly limited. The used amount thereof with respect to 100 parts by weight of the monomer component can be selected within a range of, for example, 0.01 to 5 parts by weight, or preferably 0.05 to 3 parts by weight.

In the activation of the photopolymerization initiator, it is important to apply the ultraviolet ray to a mixture of the monomer component and the photopolymerization initiator. The irradiation energy of the ultraviolet ray and the irradiation duration thereof are not particularly limited as long as the photopolymerization initiator can be activated to generate a reaction of the monomer component.

Examples of the thermal polymerization initiator include an azo-based polymerization initiator such as 2,2'-azobisisobutyronitrile, 2,2'-azobis-2-methylbutyronitrile, 2,2'-azobis(2-methylpropionic acid)dimethyl, 4,4'-azobis-4-cyanovalerianic acid, azobis isovaleronitrile, 2,2'-azobis(2-amidinopropane)dihydrochloride, 2,2'-azobis[2-(5-methyl-2-imidazoline-2-yl)propane]dihydrochloride, 2,2'-azobis(2-methylpropioneamidine) disulfate, 2,2'-azobis(N,N'-dimethylenelsobutylamidine) hydrochloride, and 2,2'-azobis[N-(2-carboxyethyl)-2-methylpropioneamidine]hydrate; a peroxide-based polymerization initiator such as dibenzoyl peroxide, t-butyl permaleate, t-butyl hydroperoxide, and hydrogen peroxide; a persulfate such as potassium persulfate and ammonium persulfate; and a redox-based polymerization initiator such as combination of persulfate and sodium hydrogen sulfite and combination of peroxide and sodium ascorbate. The used amount of the thermal polymerization initiator is not particularly limited as long as it is within a range that can be conventionally used as a polymerization initiator. When the monomer component is polymerized by a thermal polymerization method, the monomer component and the thermal polymerization initiator are dissolved in an appropriate solvent (for example, toluene or ethyl acetate) and the resulting product can be heated at a polymerization temperature of about, for example, 20 to 100°C (typically, 40 to 80°C).

### (Hydrated Metal Compound)

The (b) a hydrated metal compound constituting the flame-retardant thermally-conductive pressure-sensitive adhesive layer has a decomposition starting temperature within a range of 150 to 500°C and is a compound represented by a general formula MₘOₙ·XH₂O (wherein M is a metal, "m" and "n" are an integer of 1 or more determined by a valence of the metal, and X is the number showing the crystal water to be contained) or a double salt containing the compound. Examples of the (b) a hydrated metal compound in the present invention include an aluminum hydroxide [Al₂O₃·3H₂O; or Al(OH)₃], boehmite [Al₂O₃·H₂O; or AIOOH], a magnesium hydroxide [MgO·H₂O; or Mg(OH)₂], a calcium hydroxide [CaO·H₂O; or Ca(OH)₂], a zinc hydroxide [Zn(OH)₂], silica [H₄SiO₄; or H₂SiO₃; or H₂Si₂O₅], an iron hydroxide [Fe₂O₃·H₂O or 2FeO(OH)], a copper hydroxide [Cu(OH)₂], a barium hydroxide [BaO·H₂O; or BaO·9H₂O], a zirconium oxide hydrate [ZrO·nH₂O], a tin oxide hydrate [SnO·H₂O], a basic magnesium carbonate [3MgCO₃·Mg(OH)₂·3H₂O], hydrotalcite [6MgO·Al₂O₃·H₂O], dawsonite [Na₂CO₃·Al₂O₃·nH₂O], borax [Na₂O·B₂O₅·5H₂O], and a zinc borate [2ZnO·3B₂O₅·3.5H₂O]. Also, examples of the hydrated metal compound can include hydrotalcite and borax. These hydrated metal compounds can be used alone or in combination of two or more. Of the hydrated metal compounds, in view of high thermally conductive properties and developing high flame retardancy, particularly preferably, an aluminum hydroxide is used.

The shape of the (b) a hydrated metal compound used in the present invention is not particularly limited and examples of the shape thereof may include a bulk shape, a needle shape, a plate shape, or a layer shape. Examples of the bulk shape include a sphere shape, a rectangular parallelepiped shape, and a pulverized shape or a deformed shape thereof.

In the present invention, the particle size of the (b) a hydrated metal compound is, in the case of the hydrated metal compound in a bulk shape (a sphere shape), as the primary average particle size, 0.1 to 1000 µm, preferably 1 to 100 µm, or more preferably 5 to 80 µm. When the primary average particle size thereof is above 1000 µm, there is a disadvantage that the particle size of the hydrated metal compound exceeds the thickness of the flame-retardant thermally-conductive pressure-sensitive adhesive layer to cause the occurrence of unevenness in the thickness. The primary average particle size is a value based on volume obtained by a particle size distribution measurement method in a laser scattering method. To be specific, the primary average particle size is obtained by measuring a D50 value with a laser scattering particle size analyzer.

In the case where the (b) a hydrated metal compound is thermally conductive particles in needle shapes or plate shapes, the maximum length of each of the thermally conductive particles is 0.1 to 1000 µm, preferably 1 to 100 µm, or more preferably 5 to 45 µm. When the maximum length thereof is above 1000 µm, there is a disadvantage that the thermally conductive particles easily aggregate with each other and the handling thereof becomes difficult. In addition, the aspect ratio (in the case of a needle-shaped crystal, expressed by the length of the long axis/the length of the short axis or the length of the long axis/the thickness and in the case of a plate-shaped crystal, expressed by the diagonal length/the thickness or the length of the long side/the thickness) thereof is 1 to 10000, or preferably 1 to 1000.

In the present invention, as the (b) a hydrated metal compound, preferably, the hydrated metal compounds having a different particle size are used in combination of two or more. When the hydrated metal compounds having a different particle size are used in combination of two or more, preferably, for example, the particles having a large particle size of 5 µm or more and a small particle size of less than 5 µm, in a particle size of the hydrated metal compound, are used in combination. By using the hydrated metal compounds having a different particle size in combination in this way, there is an effect that the thermally conductive particles further closely and tightly fill the flame-retardant thermally-conductive pressure-sensitive adhesive layer and a thermally conductive path by the hydrated metal compound is easily formed, so that the thermally conductive properties are improved. In order to obtain the effect, for example, desirably, the mixing ratio (ratio by weight) of a large particle having the primary average particle size or the maximum length of 5 µm or more to a small particle having the primary average particle size or the maximum length of less than 5 µm is 1:10 to 10:1, preferably 1:5 to 5:1, or more preferably 1:2 to 2:1.

In the present invention, a commercially available product can be used as the (b) a hydrated metal compound. Examples of the commercially available product can include as the aluminum hydroxide, trade name: "HIGILITE H-100-ME" (the primary average particle size of 75 µm) (manufactured by SHOWA DENKO K.K.), trade name: "HIGILITE H-10" (the primary average particle size of 55 µm) (manufactured by SHOWA DENKO K.K.), trade name: "HIGILITE H-32" (the primary average particle size of 8 µm) (manufactured by SHOWA DENKO K.K.), and trade name: "HIGILITE H-42" (the primary average particle size of 1 µm) (manufactured by SHOWA DENKO K.K.) and trade name: "B103ST" (the primary average particle size of 8 µm) (manufactured by Nippon Light Metal Co., Ltd.) and as the magnesium hydroxide, trade name: "KISUMA 5A" (the primary average particle size of 1 µm) (manufactured by Kyowa Chemical Industry Co., Ltd).

The content of the (b) a hydrated metal compound constituting the flame-retardant thermally-conductive pressure-sensitive adhesive layer of the present invention is not particularly limited. Preferably, the content thereof with respect to 100 parts by weight of the acrylic polymer in the flame-retardant thermally-conductive pressure-sensitive adhesive layer is 100 to 500 parts by weight, preferably 200 to 450 parts by weight, or more preferably 300 to 400 parts by weight. When the content of the hydrated metal compound with respect to 100 parts by weight of the acrylic polymer is 100 to 500 parts by weight, high thermal conductivity and flame retardancy can be obtained. On the other hand, when the content thereof is less than 100 parts by weight, there may be a case where sufficient thermally conductive properties and flame retardancy cannot be imparted. When the content thereof is above 500 parts by weight, there may be a case where the flexibility is reduced, so that the pressure-sensitive adhesive force and the holding force are reduced.

In the present invention, in order to improve the thermally conductive properties, other thermally conductive particles may be contained. Examples of the thermally conductive particles capable of being used in the present invention include a boron nitride, an aluminum nitride, a silicon nitride, a gallium nitride, a silicon carbonate, a silicon dioxide, an aluminum oxide, a magnesium oxide, a titanium oxide, a zinc oxide, a tin oxide, a copper oxide, a nickel oxide, an antimony doped tin oxide, a calcium carbonate, a barium titanate, a potassium titanate, copper, silver, gold, nickel, aluminum, platinum, a carbon black, a carbon tube (a carbon nanotube), a carbon fiber, and diamond. The size (the particle size) of each of the thermally conductive particles can be used in the same manner as that in the hydrated metal compound.

In the present invention, a commercially available product can be used as the thermally conductive particles. Examples of the commercially available product can include as the boron nitride, trade name: "HP-40" (manufactured by MIZUSHIMA FERROALLOY CO., LTD.) and trade name: "PT620" (manufactured by Momentive Performance Materials Inc.); as the aluminum oxide, trade name: "AS-50" (manufactured by SHOWA DENKO K.K.); as the antimony doped tin oxide, trade name: "SN-100S" (manufactured by ISHIHARA SANGYO KAISHA, LTD.), trade name: "SN-100P" (manufactured by ISHIHARA SANGYO KAISHA, LTD.), and trade name: "SN-100D (an aqueous dispersion product)" (manufactured by ISHIHARA SANGYO KAISHA, LTD.); as the titanium oxide, trade name: the "TTO series" (manufactured by ISHIHARA SANGYO KAISHA, LTD.); and as the zinc oxide, trade name: "SnO-310" (manufactured by SUMITOMO OSAKA CEMENT Co., Ltd.), trade name: "SnO-350" (manufactured by SUMITOMO OSAKA CEMENT Co., Ltd.), and trade name: "SnO-410" (manufactured by SUMITOMO OSAKA CEMENT Co., Ltd.).

When the thermally conductive particles are used in combination in the present invention, the content thereof is not particularly limited. Preferably, the content thereof with respect to 100 parts by weight of the acrylic polymer in the flame-retardant thermally-conductive pressure-sensitive adhesive layer is, for example, 250 parts by weight or less, preferably 1 to 270 parts by weight, or more preferably 5 to 280 parts by weight. When the content of the thermally conductive particles is above 280 parts by weight, there may be a case where the flexibility of the flame-retardant thermally-conductive pressure-sensitive adhesive layer is reduced or the flame retardancy is reduced.

In order to stably disperse the hydrated metal compound and the thermally conductive particles without being aggregated, preferably, a dispersant is used in the flame-retardant thermally-conductive pressure-sensitive adhesive layer of the present invention. The dispersant is not particularly limited and preferably, phosphate ester is used. Examples of the phosphate ester include phosphoric monoester of polyoxyethylene alkyl (or alkylallyl) ether or polyoxyethylene alkyl aryl ether; phosphoric diester of polyoxyethylene alkyl ether or polyoxyethylene alkyl aryl ether; and phosphoric triester or a derivative thereof. These phosphate ester-based dispersants may be used alone or in combination of two or more. Of these, in view of temporal stability of the thermally conductive particles, preferably, phosphoric monoester and phosphoric diester of polyoxyethylene alkyl ether or polyoxyethylene alkyl aryl ether are used. Examples thereof include trade name: "PLYSURF A212E" (manufactured by DAL-ICHI KOGYO SEIYAKU CO., LTD.), trade name: "PLYSURF A210G" (manufactured by DAI-ICHI KOGYO SEIYAKU CO., LTD.), trade name: "PLYSURF A212C" (manufactured by DAI-ICHI KOGYO SEIYAKU CO., LTD.), and trade name: "PLYSURF A215C" (manufactured by DAI-ICHI KOGYO SEIYAKU CO., LTD.), trade name: "PHOSPHANOL RE610" (manufactured by TOHO Chemical Industry Co., Ltd.), trade name: "PHOSPHANOL RS710" (manufactured by TOHO Chemical Industry Co., Ltd.), and trade name: "PHOSPHANOL RS610" (manufactured by TOHO Chemical Industry Co., Ltd.). The mixing amount of the dispersant is not particularly limited and is, for example, 0.01 to 10 parts by weight, preferably 0.05 to 5 parts by weight, or more preferably 0.1 to 3 parts by weight with respect to 100 parts by weight of the acrylic polymer. In the present invention, in order to improve the flame retardancy, another flame retardant may be contained as long as it does not adversely affect the adhesive properties and the thermally conductive properties. Examples of the flame retardant capable of being used in the present invention include a metal carboxylate such as basic magnesium carbonate, magnesium-calcium carbonate, calcium carbonate, barium carbonate, and dolomite; a barium metaborate; a magnesium oxide; an ammonium polyphosphate; a zinc borate; a tin compound; an organophosphate; a red phosphate; a carbon black; and a silicone-based flame retardant.

When the flame retardant is used in the present invention, the content thereof is not particularly limited. The content thereof with respect to 100 parts by weight of the acrylic polymer in the flame-retardant thermally-conductive pressure-sensitive adhesive layer is 250 parts by weight or less. When the content of the flame retardant is above 250 parts by weight, there may be a case where the adhesive properties are remarkably reduced due to the bleed out of the monomer or the thermally conductive properties are reduced. Preferably, the content of the flame retardant with respect to 100 parts by weight of the acrylic polymer is preferably 1 to 270 parts by weight, or more preferably 5 to 280 parts by weight.

In the present invention, when the thermally conductive particles and/or the flame retardant are/is used in combination with the (b) a hydrated metal compound, preferably, the total amount thereof with respect to 100 parts by weight of the acrylic polymer in the flame-retardant thermally-conductive pressure-sensitive adhesive layer is 100 to 500 parts by weight, preferably 200 to 450 parts by weight, or more preferably 300 to 400 parts by weight. When the content of the hydrated metal compound, the thermally conductive particles, and/or the flame retardant with respect to 100 parts by weight of the acrylic polymer is 100 to 500 parts by weight, high thermal conductivity and flame retardancy can be obtained. On the other hand, when the content of the hydrated metal compound, the thermally conductive particles, and/or the flame retardant is less than 100 parts by weight, sufficient thermally conductive properties and flame retardancy may not be capable of being imparted. When the content of the hydrated metal compound, the thermally conductive particles, and/or the flame retardant is above 500 parts by weight, there may be a case where the flexibility is reduced and the pressure-sensitive adhesive force and the holding force are reduced.

In the present invention, when the thermally conductive particles and/or the flame retardant are/is used in combination with the (b) a hydrated metal compound, preferably, the content ratio of the hydrated metal compound with respect to the total amount of the hydrated metal compound, the thermally conductive particles, and/or the flame retardant is 50 weight % or more, preferably 60 weight % or more, or more preferably 70 weight % or more. When the content ratio of the hydrated metal compound is 50 weight % or more, high thermal conductivity and flame retardancy can be obtained. On the other hand, when the content ratio of the hydrated metal compound is less than 50 weight %, sufficient thermally conductive properties and flame retardancy may not be capable of being imparted.

### (Bubbles)

In the flame-retardant thermally-conductive pressure-sensitive adhesive sheet of the present invention, the flame-retardant thermally-conductive pressure-sensitive adhesive layer can contain bubbles. By allowing the flame-retardant thermally-conductive pressure-sensitive adhesive layer to contain the bubbles, a thickness and cushioning properties can be imparted to the flame-retardant thermally-conductive pressure-sensitive adhesive sheet, so that the followability to uneven surface between the flame-retardant thermally-conductive pressure-sensitive adhesive sheet and the adherend is improved.

The content of the bubbles can be appropriately selected as long as it does not damage the thermally conductive properties or the like of the flame-retardant thermally-conductive pressure-sensitive adhesive sheet and is usually 5 to 50 volume %, preferably 10 to 40 volume %, or more preferably 12 to 35 volume % with respect to the total volume of the flame-retardant thermally-conductive pressure-sensitive adhesive layer. When the amount of bubbles is less than 5 volume %, the adhesiveness to the adherend and the followability to unevenness thereof are often poor. When the amount of bubbles is above 50 volume %, there may be a case where the heat insulating effect by the bubbles becomes too large, so that the thermally conductive properties are reduced; the bubbles that penetrate through a sheet are formed, so that the adhesive properties become poor; or the flame-retardant thermally-conductive pressure-sensitive adhesive layer becomes too soft, so that the shearing force becomes poor.

Desirably, the bubbles to be mixed in the flame-retardant thermally-conductive pressure-sensitive adhesive layer are basically the bubbles of closed-cell type. However, the bubbles of closed-cell type and those of open-cell type may be present in mixture.

The bubbles usually have sphere shapes. Alternatively, the bubbles may have distorted sphere shapes. The average bubble size (the diameter) of each of the bubbles is not particularly limited and can be selected within a range of, for example, 1 to 1000 µm, preferably 10 to 500 µm, or more preferably 30 to 300 µm.

A gas component contained in the bubbles (a gas component that forms the bubbles; may be referred to as a "bubble-forming gas") is not particularly limited and examples thereof can include an inert gas such as nitrogen, carbon dioxide, and argon or various other gas components such as air. It is important to use a bubble-forming gas that does not inhibit a reaction when the reaction such as a polymerization reaction is performed after mixing of the bubble-forming gas. As the bubble-forming gas, in view of not inhibiting a reaction and cost, preferably, nitrogen is used.

A method for mixing the bubbles is not particularly limited. Preferably, it is desirable that a bubble-containing precursor composition is formed by mixing (c) bubbles into a precursor composition of the flame-retardant thermally-conductive pressure-sensitive adhesive layer (hereinafter, may be referred to as a "precursor composition") containing a mixture of a monomer component containing an alkyl (meth)acrylate as a main component and containing 5 weight % or more of a polar group-containing monomer in the monomer component or a partial polymer thereof and the hydrated metal compound, and then, an ultraviolet ray is applied to the obtained bubble-containing precursor composition to form the flame-retardant thermally-conductive pressure-sensitive adhesive layer.

As a method for mixing the bubbles, a known bubble-mixing method can be used. An example of a device includes a device in which on a disk having a through hole in the center thereof, a stator with many small teeth and a rotor that is opposed to the stator with teeth and has the same small teeth as those of the stator on the disk are provided. The precursor composition is introduced between the teeth on the stator and the teeth on the rotor in the device and the gas component (the bubble-forming gas) for forming the bubbles via the through hole is introduced into the precursor composition, while the rotor is allowed to run at high speed, so that the bubble-containing precursor composition in which the bubble-forming gas is finely dispersed to be mixed in the precursor composition can be obtained.

In order to suppress or prevent integration of the bubbles, preferably, the steps from mixing of the bubbles to forming of the flame-retardant thermally-conductive pressure-sensitive adhesive layer are continuously performed as a series of steps. That is, after preparing the bubble-containing precursor composition by allowing the bubbles to be mixed as described above, subsequently, the flame-retardant thermally-conductive pressure-sensitive adhesive layer is preferably formed using the bubble-containing precursor composition by an appropriate forming method.

### (Fluorine-Based Surfactant)

In the present invention, a fluorine-based surfactant can be blended into the bubble-containing precursor composition. By using the fluorine-based surfactant, degree of adhesiveness and frictional resistance of the hydrated metal compound and the acrylic polymer in the flame-retardant thermally-conductive pressure-sensitive adhesive layer are reduced and stress dispersibility is developed. Thus, the flame-retardant thermally-conductive pressure-sensitive adhesive layer of the present invention can obtain high adhesive properties. In addition to the reduction effects such as the above-described fictional resistance by having a fluorine-based hydrocarbon group, effects of increasing bubble mixing properties and bubble stability can be also obtained.

An example of the fluorine-based surfactant includes a fluorine-based surfactant having, in a molecule, an oxyC₂₋₃ alkylene group and a fluorine-based hydrocarbon group. The oxyC₂₋₃ alkylene group is represented by a formula: -R-O- (R represents a straight chain or branched chain alkylene group having 2 or 3 carbon atoms). The fluorine-based surfactant is not particularly limited as long as it has an oxyC₂₋₃ alkylene group and a fluorine-based hydrocarbon group. In view of dispersibility with respect to the acrylic polymer, preferably, a non-ionic surfactant is used. The fluorine-based surfactant may have, in a molecule, any one of an oxyethylene group (-CH₂CH₂O-) and an oxypropylene group [-CH₂CH(CH₃)O-] or two or more thereof. These fluorine-based surfactants can be used alone or in combination of two or more.

The fluorine-based hydrocarbon group is not particularly limited and preferably, a perfluoro group is used. The perfluoro group may be monovalent or may be polyvalent such as divalent or higher valent. The fluorine-based hydrocarbon group may have a double bond or a triple bond and may have a straight chain, a branched chain, or a cyclic structure. The number of carbon atoms of the fluorine-based hydrocarbon group is not particularly limited and is 1 or 2 or more, preferably 3 to 30, or more preferably 4 to 20. One or two or more fluorine-based hydrocarbon group(s) is/are introduced into a molecule of the surfactant. Examples of a form of the oxyC₂₋₃ alkylene group may include any one of an alcohol in which a hydrogen atom is bonded to an oxygen atom at the end, ether in which another hydrocarbon group is bonded to an oxygen atom at the end, and ester in which another hydrocarbon group is bonded to an oxygen atom via a carbonyl group. An example of a form of the oxyC₂₋₃ alkylene group may also include a form having the structure in a part of the cyclic structure such as cyclic ethers and lactones.

The structure of the fluorine-based surfactant is not particularly limited and for example, a copolymer that contains, as monomer components, a monomer having an oxyC₂₋₃ alkylene group and a monomer having a fluorine-based hydrocarbon group can be preferably used. As a form of the copolymer, various forms such as a block copolymer and a graft copolymer are used. Any one of these is preferably used.

Examples of the block copolymer (a copolymer having an oxyC₂₋₃ alkylene group and a fluorine-based hydrocarbon group in the main chain) include polyoxyethylene perfluoroalkyl ether, polyoxyethylene perfluoroalkylate, polyoxypropylene perfluoroalkyl ether, polyoxyisopropylene perfluoroalkyl ether, polyoxyethylene sorbitan perfluoroalkylate, polyoxyethylene polyoxypropylene block copolymer perfluoroalkylate, and polyoxyethylene glycol perfluoroalkylate.

An example of the graft copolymer (a copolymer having an oxyC₂₋₃ alkylene group and a fluorine-based hydrocarbon group in a side chain) includes a copolymer containing, as monomer components, at least a vinyl compound having a polyoxyalkylene group and a vinyl compound having a fluorine-based hydrocarbon group. Preferably, an acrylic copolymer, in particular, is used. An example of the vinyl compound having a polyoxyalkylene group includes a polyoxyalkylene (meth)acrylate such as polyoxyethylene (meth)acrylate, polyoxypropylene (meth)acrylate, and polyoxyethylene polyoxypropylene (meth)acrylate. An example of the vinyl compound having a fluorine-based hydrocarbon group includes (meth)acrylate ester having a fluorine-based hydrocarbon group such as a perfluoroalkyl (meth)acrylate including perfluorobutyl (meth)acrylate, perfluoroisobutyl (meth)acrylate, and perfluoropentyl (meth)acrylate.

The fluorine-based surfactant may have a structure such as an alicyclic hydrocarbon group or an aromatic hydrocarbon group in a molecule, other than the above-described structure. The fluorine-based surfactant may have various functional groups such as a carboxyl group, a sulfonic acid group, a cyano group, an amide group, and an amino group as long as it does not inhibit the dispersibility with respect to the acrylic polymer. When the fluorine-based surfactant is a vinyl copolymer, as the monomer component, for example, a monomer component that is copolymerizable with a vinyl compound having a polyoxyalkylene group and a vinyl compound having a fluorine-based hydrocarbon group may be used. These monomers can be used alone or in combination of two or more.

Preferably, examples of the above-described copolymerizable monomer component include a C₁₋₂₀ alkyl (meth)acrylate such as undecyl (meth)acrylate and dodecyl (meth)acrylate; (meth)acrylate ester having an alicyclic hydrocarbon group such as cyclopentyl (meth)acrylate; and (meth)acrylate ester having an aromatic hydrocarbon group such as phenyl (meth)acrylate. Other than those, examples thereof also include a carboxyl group-containing monomer such as maleic acid and crotonic acid; a sulfonic acid group-containing monomer such as sodium vinylsulfonate; an aromatic vinyl compound such as styrene and vinyltoluene; olefins or dienes such as ethylene and butadiene; vinyl ethers such as vinyl alkyl ether; an amide group-containing monomer such as acrylamide; an amino group-containing monomer such as (meth)acryloylmorpholine; a glycidyl group-containing monomer such as methylglycidyl (meth)acrylate; and an isocyanate group-containing monomer such as 2-methacryloyloxyethyl isocyanate. Furthermore, examples thereof may include a polyfunctional copolymerizable monomer (a polyfunctional monomer) such as dipentaerythritol hexa(meth)acrylate and divinylbenzene.

The weight average molecular weight of the fluorine-based surfactant is not particularly limited and when the weight average molecular weight is less than 20000 (for example, 500 or more and less than 20000), the effects of reducing the adhesiveness and the frictional resistance between the acrylic polymer in the flame-retardant thermally-conductive pressure-sensitive adhesive layer and the thermally conductive particles are high. In addition, when the fluorine-based surfactants each having a weight average molecular weight of 20000 or more (for example, 20000 to 100000, preferably 22000 to 80000, or more preferably 24000 to 60000) are used in combination, the bubble mixing properties and the bubble stability of the mixed bubbles are increased.

Specific examples of the fluorine-based surfactant having an oxyC₂₋₃ alkylene group and a fluorine-based hydrocarbon group and having a weight average molecular weight of less than 20000 include trade name: "FTERGENT 251" (manufactured by NEOS COMPANY LIMITED), trade name: "FTX-218" (manufactured by NEOS COMPANY LIMITED), trade name: "MEGAFAC F-477" (manufactured by DIC Corporation), trade name: "MEGAFAC F-470" (manufactured by DIC Corporation), trade name: "SURFLON S-381" (manufactured by AGC SEIMI CHEMICAL CO., LTD.), trade name: "SURFLON S-383" (manufactured by AGC SEIMI CHEMICAL CO., LTD.), trade name: "SURFLON S-393" (manufactured by AGC SEIMI CHEMICAL CO., LTD.), trade name: "SURFLON KH-20" (manufactured by AGC SEIMI CHEMICAL CO., LTD.), and trade name: "SURFLON KH-40" (manufactured by AGC SEIMI CHEMICAL CO., LTD.). Specific examples of the fluorine-based surfactant having an oxyC₂₋₃ alkylene group and a fluorine-based hydrocarbon group and having a weight average molecular weight of 20000 or more include trade name: "EFTOP EF-352" (manufactured by JEMCO Inc.), trade name: "EFTOP EF-801" (manufactured by JEMCO Inc.), and trade name: "Unidyne TG-656" (manufactured by DAIKIN INDUSTRIES, ltd.). Any one of these can be preferably used in the present invention.

The used amount (the solid content) of the fluorine-based surfactant is not particularly limited and can be selected within a range of, for example, 0.01 to 5 parts by weight, preferably 0.02 to 3 parts by weight, or more preferably 0.03 to 2 parts by weight with respect to 100 parts by weight of the total monomer component for forming the acrylic polymer in the flame-retardant thermally-conductive pressure-sensitive adhesive layer. When the used amount thereof is less than 0.01 parts by weight, the stability of the bubbles may not be easily obtained and when the used amount thereof is above 5 parts by weight, the adhesive properties may be reduced.

In the present invention, the dispersant, which stably disperses the above-described hydrated metal compound, and the fluorine-based surfactant, which reduces the degree of adhesiveness and the frictional resistance between the hydrated metal compound and the acrylic polymer in the flame-retardant thermally-conductive pressure-sensitive adhesive layer and develops the stress dispersibility, can be used in combination. By using the dispersant and the fluorine-based surfactant in combination, the hydrated metal compound is capable of being stably present without aggregating in the flame-retardant thermally-conductive pressure-sensitive adhesive layer by a smaller amount than when the dispersant or the fluorine-based surfactant is used alone, leading to the improvement of the thermally conductive properties. The stress dispersibility of the flame-retardant thermally-conductive pressure-sensitive adhesive layer is improved and further higher adhesive properties can be expected. When the two additives are used in combination, the mixing amount thereof is not particularly limited and desirably, the additives are used at a ratio (ratio by weight) of the dispersant to the fluorine-based surfactant of 1:20 to 20:0.01, preferably 1:10 to 10:0.01, or more preferably 1:5 to 5:0.01.

In the present invention, in order to stably mix the bubbles to be present in the flame-retardant thermally-conductive pressure-sensitive adhesive layer, preferably, the bubbles are blended to be mixed as the last component in the precursor composition, and in particular, the viscosity of the precursor composition before the bubbles are mixed therein is preferably increased. The viscosity of the precursor composition is not particularly limited as long as it is the viscosity that is capable of stably retaining the mixed bubbles. For example, desirably, the viscosity measured by using a BH viscometer as a viscometer under the conditions of a rotor: a No. 5 rotor, the number of rotations: 10 rpm, and a measurement temperature: 30°C is 5 to 50 Pa·s (preferably, 10 to 40 Pa·s). When the viscosity (a BH viscometer, a No. 5 rotor, 10 rpm, 30°C) of the precursor composition is less than 5 Pa·s, there may be a case where the viscosity is too low and the mixed bubbles are easily integrated to be released outside the system. On the other hand, when the viscosity thereof is above 50 Pa·s, the viscosity is too high in forming of the flame-retardant thermally-conductive pressure-sensitive adhesive layer, so that the application becomes difficult.

The viscosity of the precursor composition can be adjusted by, for example, a method in which various polymer components such as an acrylic rubber and a thickening additive are blended or a method in which a monomer component for forming an acrylic polymer (for example, a monomer component such as (meth)acrylate ester for forming an acrylic polymer or the like) is partially polymerized to serve as a partial polymer. To be specific, for example, a monomer component for forming an acrylic polymer (for example, a monomer component such as (meth)acrylate ester for forming an acrylic polymer or the like) and a polymerization initiator (for example, a photopolymerization initiator, a thermal polymerization initiator, or the like) are mixed to prepare a monomer mixture. A polymerization reaction in accordance with the type of the polymerization initiator is performed with respect to the monomer mixture and a composition

(a syrup) containing a partial polymer in which a part of the monomer component only is polymerized is prepared. Thereafter, the hydrated metal compound and, if necessary, the monomer, the dispersant, the fluorine-based surfactant, and various additives to be described later are blended into the syrup, so that the precursor composition having an appropriate viscosity at which the bubbles are capable of being stably contained can be prepared. By introducing the bubbles into the precursor composition to be mixed, the bubble-containing precursor composition that stably contains the bubbles can be obtained. In the preparation of the syrup, the fluorine-based surfactant and the hydrated metal compound may be appropriately blended in the monomer mixture in advance.

In the present invention, in order to adjust the cohesive force of the flame-retardant thermally-conductive pressure-sensitive adhesive layer, other than the above-described method in which the polyfunctional monomer is blended to introduce the cross-linking structure into the acrylic polymer, a cross-linking agent is capable of being used. As the cross-linking agent, a cross-linking agent that is usually used can be used. Examples thereof include an epoxy cross-linking agent, an isocyanate cross-linking agent, a silicone cross-linking agent, an oxazoline cross-linking agent, an aziridine cross-linking agent, a silane cross-linking agent, an alkyletherified melamine cross-linking agent, and a metal chelate cross-linking agent. Preferably, an isocyanate cross-linking agent and an epoxy cross-linking agent, in particular, can be used.

To be specific, examples of the isocyanate cross-linking agent include tolylene diisocyanate, hexamethylene diisocyanate, isophorone diisocyanate, xylylene diisocyanate, hydrogenated xylylene diisocyanate, diphenylmethane diisocyanate, hydrogenated diphenylmethane diisocyanate, tetramethyl xylylene diisocyanate, naphthalene diisocyanate, triphenylmethane triisocyanate, and polymethylene polyphenyl isocyanate and an adduct of the above-described component with a polyol such as trimethylol propane. Also, as the isocyanate cross-linking agent, a compound containing, in a molecule, at least one or more isocyanate group(s) and one or more unsaturated bond(s), to be specific, a 2-isocyanate ethyl (meth)acrylate or the like can be used.

Examples of the epoxy cross-linking agent include bisphenol A, epichlorohydrin type epoxy resin, ethylene glycidyl ether, polyethylene glycol diglycidyl ether, glycerin diglycidyl ether, glycerin triglycidyl ether, 1,6-hexanediol glycidyl ether, trimethylolpropane triglycidyl ether, diglycidyl aniline, diamine glycidyl amine, N,N,N',N'-tetraglycidyl-m-xylylene diamine, and 1,3-bis(N,N'-diamine glycidyl aminomethyl)cyclohexane.

In the present invention, when the cross-linking agent is used, the content thereof is not particularly limited. Preferably, the content thereof with respect to 100 parts by weight of the acrylic polymer in the flame-retardant thermally-conductive pressure-sensitive adhesive layer is, 0.01 to 5 parts by weight, preferably 0.01 to 3 parts by weight, or more preferably 0.01 to 2 parts by weight. When the content of the cross-linking agent is above 5 parts by weight, the flexibility may not be capable of being obtained. When the content thereof is less than 0.01 parts by weight, the cohesive properties may not be capable of being obtained.

In order to improve the adhesive properties, a tackifier resin can be contained in the flame-retardant thermally-conductive pressure-sensitive adhesive layer of the present invention. The tackifier resin is not particularly limited. When the acrylic polymer is obtained by copolymerizing the monomer component by polymerization using an ultraviolet ray, a hydrogenated tackifier resin is preferably used because polymerization inhibition does not easily occur even when the hydrogenated tackifier resin is used in combination. The hydrogenated tackifier resin can be selected from a derivative obtained by hydrogenating a tackifier resin. Examples of the tackifier resin include a petroleum resin, a terpene-based resin, a coumarone indene resin, a styrene-based resin, a rosin-based resin, an alkyl phenol resin, and a xylene resin. The system of the hydrogenated petroleum resin can be selected from aromatic, dicyclopentadiene, aliphatic, aromatic-dicyclopentadiene copolymer, or the like. The hydrogenated terpene-based resin can be selected from a terpene phenol resin, an aromatic terpene resin, or the like. Of these, preferably, a petroleum resin or a terpene-based resin, in particular, is used.

The softening point of the tackifier resin is preferably 80 to 200°C, or more preferably 100 to 200°C. By adjusting the softening point of the tackifier resin within the above-described range, the effect of obtaining a high cohesive force is capable of being obtained.

In the present invention, when the tackifier resin is used, the content thereof is not particularly limited and is preferably 1 to 50 parts by weight, more preferably 2 to 40 parts by weight, or particularly preferably 3 to 30 parts by weight with respect to 100 parts by weight of the acrylic polymer in the flame-retardant thermally-conductive pressure-sensitive adhesive layer. When the added amount of the tackifier resin is above 50 parts by weight, the cohesive force may be reduced. When the added amount thereof is less than 1 part by weight, the effect of improving the adhesive force may not be capable of being obtained.

In the present invention, in order to improve the adhesive properties, an acrylic oligomer can be contained. The acrylic oligomer is a polymer that has a higher glass transition temperature (Tg) and a lower weight average molecular weight than those of the (a) an acrylic polymer. The acrylic oligomer has an advantage that it functions as a tackifier resin and does not easily generate polymerization inhibition in polymerization using an ultraviolet ray.

In the present invention, desirably, the acrylic oligomer has a glass transition temperature (Tg) of about 0°C or more and 300°C or less, preferably of about 20°C or more and 300°C or less, or more preferably of about 40°C or more and 300°C or less. When the glass transition temperature (Tg) is less than about 0°C, there may be a case where the cohesive force at the room temperature or more of the flame-retardant thermally-conductive pressure-sensitive adhesive layer is reduced, and the holding properties and the adhesive properties at a high temperature are reduced. The Tg of the acrylic oligomer can be calculated based on the formula of Fox in the same manner as in the Tg of the (a) an acrylic polymer.

The weight average molecular weight of the acrylic oligomer is 1000 or more and less than 30000, preferably 1500 or more and less than 20000, or more preferably 2000 or more and less than 10000. When the weight average molecular weight is 30000 or more, the effect of improving the adhesive force may not be capable of being sufficiently obtained. When the weight average molecular weight is less than 1000, the acrylic oligomer has a low molecular weight, so that a reduction in the adhesive force and the holding properties may occur.

In the present invention, the weight average molecular weight of the acrylic oligomer can be measured by a GPC method with standard polystyrene calibration. To be specific, the weight average molecular weight of the acrylic oligomer is measured by using TSKgel GMH-H(20) × 2 as a column in HPLC8020 manufactured by TOSOH CORPORATION by a tetrahydrofuran solvent under the conditions of a flow rate of about 0.5 ml/min.

In the present invention, examples of the monomer constituting the acrylic oligomer include an alkyl (meth)acrylate such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, isopentyl (meth)acrylate, hexyl (meth)acrylate, 2-ethylhexyl (meth)acrylate, heptyl (meth)acrylate, octyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, and dodecyl (meth)acrylate; ester of (meth)acrylic acid with an alicyclic alcohol such as cyclohexyl (meth)acrylate and isobornyl (meth)acrylate; aryl (meth)acrylate such as phenyl (meth)acrylate and benzyl (meth)acrylate; and (meth)acrylate obtained from a terpene compound derivative alcohol. These (meth)acrylates can be used alone or in combination of two or more.

Preferably, the (meth)acrylate oligomer contains, as a monomer unit, an acrylic monomer having a relatively bulky structure. Examples thereof include an alkyl (meth)acrylate in which an alkyl group has a branched structure such as isobutyl (meth)acrylate and t-butyl (meth)acrylate; ester of (meth)acrylic acid with an alicyclic alcohol such as cyclohexyl (meth)acrylate and isobornyl (meth)acrylate; and a (meth)acrylate having a cyclic structure such as aryl (meth)acrylate including phenyl (meth)acrylate and benzyl (meth)acrylate. By allowing the acrylic oligomer to have the bulky structure, the adhesive properties of the flame-retardant thermally-conductive pressure-sensitive adhesive layer can be further improved. In view of bulkiness, in particular, an acrylic oligomer having a cyclic structure is effective and an acrylic oligomer having a plurality of rings is even more effective. When an ultraviolet ray is used in synthesis of the acrylic oligomer and fabrication of the flame-retardant thermally-conductive pressure-sensitive adhesive layer, in view of not easily generating polymerization inhibition, an acrylic oligomer having a saturated bond is preferably used. As a monomer constituting the acrylic oligomer, a (meth)acrylate in which an alkyl group has a branched structure or ester with an alicyclic alcohol can be preferably used.

In this view, in the present invention, examples of the acrylic oligomer include a copolymer of cyclohexyl methacrylate (CHMA) and isobutyl methacrylate (IBMA); a copolymer of cyclohexyl methacrylate (CHMA) and isobornyl methacrylate (IBXMA); a copolymer of cyclohexyl methacrylate (CHMA) and acryloyl morpholine (ACMO); a copolymer of cyclohexyl methacrylate (CHMA) and diethylacrylamide (DEAA); a copolymer of 1-adamantyl acrylate (ADA) and methyl methacrylate (MMA); a copolymer of dicyclopentanyl methacrylate (DCPMA) and isobornyl methacrylate (IBXMA); and a homopolymer such as dicyclopentanyl methacrylate (DCPMA), cyclohexyl methacrylate (CHMA), isobornyl methacrylate (IBXMA), isobornyl acrylate (IBXA), dicyclopentanyl acrylate (DCPA), 1-adamantyl methacrylate (ADMA), and 1-adamantyl acrylate (ADA).

In the present invention, when the acrylic oligomer is used, the content thereof is not particularly limited and is 1 to 70 parts by weight, preferably 2 to 50 parts by weight, or more preferably 3 to 40 parts by weight with respect to 100 parts by weight of the acrylic polymer in the flame-retardant thermally-conductive pressure-sensitive adhesive layer. When the added amount of the acrylic oligomer is above 70 parts by weight, there may be a case where the cohesive force is reduced or a case where the elastic modulus becomes high and the adhesive properties at a low temperature becomes poor and the pressure-sensitive adhesive force is not developed at a room temperature. When the added amount of the acrylic oligomer is less than 1 part by weight, the effect of improving the adhesive force may not be capable of being obtained.

For the purpose of further improving the adhesive force, the durability, and the affinity between the hydrated metal compound and the acrylic polymer, a silane coupling agent can be used in the flame-retardant thermally-conductive pressure-sensitive adhesive layer of the present invention. As the silane coupling agent, a known silane coupling agent can be appropriately used without any particular limitation.

To be specific, examples of the silane coupling agent include an epoxy group-containing silane coupling agent such as 3-glycidoxypropyltrimethoxysilane, 3-glycidoxypropyltriethoxysilane, 3-glycidoxypropylmethyldiethoxysilane, and 2-(3,4-epoxycyclohexyl)ethyltrimethoxysilane; an amino group-containing silane coupling agent such as 3-aminopropyltrimethoxysilane, N-2-(aminoethyl)-3-aminopropylmethyldimethoxysilane, and 3-triethoxysilyl-N-(1,3-dimethylbutylidene)propylamine; a (meth)acrylic group-containing silane coupling agent such as 3-acryloxypropyltrimethoxysilane and 3-methacryloxypropyltriethoxysilane; and an isocyanate group-containing silane coupling agent such as 3-isocyanatepropyltriethoxysilane. These silane coupling agents may be used alone or in combination of two or more.

The content of the above-described silane coupling agent with respect to 100 parts by weight of the above-described acrylic polymer is preferably 0.01 to 10 parts by weight, more preferably 0.02 to 5 parts by weight, or further more preferably 0.05 to 2 parts by weight. By using the above-described silane coupling agent within the above-described range, the cohesive force and the durability can be further surely improved. On the other hand, when the content thereof is less than 0.01 parts by weight, there may be a case where the surfaces of the thermally conductive particles contained in the flame-retardant thermally-conductive pressure-sensitive adhesive layer cannot be covered and the affinity is not improved. On the other hand, when the content thereof is above 10 parts by weight, the thermally conductive properties may be reduced.

### (Other Components)

In the present invention, in addition to the (a) an acrylic polymer, the (b) a hydrated metal compound, the above-described bubbles, and various components, an appropriate additive may be contained in the flame-retardant thermally-conductive pressure-sensitive adhesive layer in accordance with the use of the flame-retardant thermally-conductive pressure-sensitive adhesive layer. An appropriate additive such as a plasticizer, a filler, an oxidation inhibitor, and a colorant (a pigment, a dye, or the like) may be contained therein.

### (Fabrication of Flame-Retardant Thermally-Conductive Pressure-Sensitive Adhesive Layer)

In the flame-retardant thermally-conductive pressure-sensitive adhesive sheet of the present invention, when the flame-retardant thermally-conductive pressure-sensitive adhesive layer is formed using a flame-retardant thermally-conductive pressure-sensitive adhesive composition containing at least (a) an acrylic polymer and (b) a hydrated metal compound, a known forming method can be used. For example, a monomer component for forming an acrylic polymer, a polymerization initiator (for example, a photopolymerization initiator or a thermal polymerization initiator), and an appropriate solvent (toluene, ethyl acetate, or the like) are mixed to prepare a monomer solution and a polymerization reaction is performed with respect to the monomer solution in accordance with the type of the polymerization initiator, so that a polymer solution containing the acrylic polymer in which the monomer component is copolymerized is prepared. Thereafter, a hydrated metal compound and, if necessary, various additives are blended into the polymer solution, so that the flame-retardant thermally-conductive pressure-sensitive adhesive composition having a viscosity appropriate for application is prepared. The flame-retardant thermally-conductive pressure-sensitive adhesive composition is applied onto a predetermined surface and then, drying, curing, and the like are performed as required, so that the flame-retardant thermally-conductive pressure-sensitive adhesive layer can be formed.

In the present invention, when the curing using an ultraviolet ray is used, a monomer component for forming an acrylic polymer and a photopolymerization initiator are mixed to prepare a monomer mixture. The ultraviolet ray is applied to the monomer mixture and a composition (a syrup) containing a partial polymer in which a part of the monomer component only is polymerized is prepared. Thereafter, the hydrated metal compound and, if necessary, the monomer, the dispersant, the fluorine-based surfactant, and various additives are blended into the syrup, so that a precursor composition having a viscosity appropriate for application is prepared. The precursor composition is applied onto a predetermined surface, then, the ultraviolet ray is applied thereto, and the applied product is cured, so that the flame-retardant thermally-conductive pressure-sensitive adhesive layer can be formed.

In the present invention, when the flame-retardant thermally-conductive pressure-sensitive adhesive layer having the bubbles is obtained, by introducing the bubbles into the precursor composition to be mixed, so that a bubble-containing precursor composition is obtained. The bubble-containing precursor composition is applied onto a predetermined surface, then, the ultraviolet ray is applied thereto, and the applied product is cured, so that the flame-retardant thermally-conductive pressure-sensitive adhesive layer having the bubbles can be formed.

As a coating method in application of the flame-retardant thermally-conductive pressure-sensitive adhesive composition or the precursor composition onto a predetermined surface, a coating method that has been conventionally widely used can be used. For example, a coating liquid is applied onto a substrate including a polyester film or a release liner to be dried and then, another release liner is bonded thereto, so that the flame-retardant thermally-conductive pressure-sensitive adhesive layer can be fabricated. An example of the forming method of the flame-retardant thermally-conductive pressure-sensitive adhesive layer of the present invention includes an extrusion coating method using roll coater, kiss roll coater, gravure coater, reverse coater, roll brush coater, spray coater, dip roll coater, bar coater, knife coater, air knife coater, curtain coater, lip coater, die coater, or the like.

In the present invention, the thickness of the flame-retardant thennally-conductive pressure-sensitive adhesive layer is not particularly limited and can be selected within a range of, for example, 10 to 250 µm, preferably 20 to 200 µm, or more preferably 30 to 100 µm. When the thickness of the flame-retardant thermally-conductive pressure-sensitive adhesive layer is less than 10 µm, a sufficient adhesive force and holding force may not be capable of being obtained. On the other hand, when the thickness thereof is above 250 µm, sufficient thermally conductive properties may not be capable of being obtained.

In the present invention, the tensile elastic modulus of the flame-retardant thermally-conductive pressure-sensitive adhesive sheet is preferably 10 to 600 MPa, or more preferably 20 to 500 MPa. When the tensile elastic modulus thereof is within this range, there is an advantage that the elongation of the flame-retardant thermally-conductive pressure-sensitive adhesive sheet is appropriate and the bonding properties with respect to an adherend are excellent. On the other hand, when the tensile elastic modulus of the flame-retardant thermally-conductive pressure-sensitive adhesive sheet is 10 MPa or less, there may be a case where the flame-retardant thermally-conductive pressure-sensitive adhesive sheet extends at the time of being bonded, so that a bonding defect occurs. When the tensile elastic modulus of the flame-retardant thermally-conductive pressure-sensitive adhesive sheet is above 600 MPa, the flame-retardant thermally-conductive pressure-sensitive adhesive sheet may not be bonded because it repels. The tensile elastic modulus is measured in accordance with the description of the evaluation of Examples to be described later.

### (Pressure-Sensitive Adhesive Layer (Non-Flame Retardant Thermally-Conductive Pressure-Sensitive Adhesive Layer))

In the flame-retardant thermally-conductive pressure-sensitive adhesive sheet of the present invention, a pressure-sensitive adhesive layer (a non-flame retardant thermally-conductive pressure-sensitive adhesive layer), other than the flame-retardant thermally-conductive pressure-sensitive adhesive layer, can be provided as a pressure-sensitive adhesive layer as long as it does not damage the effect of the present invention. When a flame-retardant thermally-conductive pressure-sensitive adhesive layer is provided on one surface of a substrate and a non-flame retardant thermally-conductive pressure-sensitive adhesive layer is provided on the other surface thereof (FIG. 1 (c)), the non-flame retardant thermally-conductive pressure-sensitive adhesive layer can be formed by a known forming method of the pressure-sensitive adhesive layer using a known pressure-sensitive adhesive (for example, an acrylic pressure-sensitive adhesive, a rubber-based pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, a fluorine-based pressure-sensitive adhesive, an epoxy-based pressure-sensitive adhesive, or the like). The thickness of the non-flame retardant thermally-conductive pressure-sensitive adhesive layer is not particularly limited and can be appropriately selected in accordance with the purpose, the usage, or the like.

### (Release Liner)

In the present invention, in order to protect the adhesive surface (the pressure-sensitive adhesive surface) of the pressure-sensitive adhesive layer such as the flame-retardant thermally-conductive pressure-sensitive adhesive layer and the non-flame retardant thermally-conductive pressure-sensitive adhesive layer, a release liner may be used. That is, it is not always necessary to use the release liner. The release liner is peeled off at the time of using the adhesive surface that is protected by the release liner (that is, at the time of bonding an adherend to the pressure-sensitive adhesive layer that is protected by the release liner).

As the release liner, a conventional release paper or the like can be used. To be specific, an example of the release liner includes a substrate having a release treated layer by a release treating agent on at least one surface thereof. In addition to this, examples thereof can include a low adhesive substrate formed of a fluorine-based polymer (for example, polytetrafluoroethylene, polychlorotrifluoroethylene, polyvinyl fluoride, polyvinylidene fluoride, a tetrafluoroethylene-hexafluoropropylene copolymer, a chlorofluoroethylene-vinylidene fluoride copolymer, or the like) and a low adhesive substrate formed of a non-polar polymer (for example, an olefin-based resin such as polyethylene and polypropylene).

As the release liner, for example, a release liner in which a release treated layer is formed on at least one surface of a release liner substrate can be preferably used. Examples of the release liner substrate include a plastic substrate film (a synthetic resin film) such as a polyester film (a polyethylene terephthalate film or the like), an olefin-based resin film (a polyethylene film, a polypropylene film, or the like), a polyvinyl chloride film, a polyimide film, a polyamide film (a nylon film), and a rayon film and papers (wood free paper, Japanese paper, kraft paper, glassine paper, synthetic paper, top-coated paper, or the like). In addition to these, an example thereof also includes a multilayered component (a complex having two or three layers) of the above-described components by lamination, co-extrusion, or the like.

On the other hand, the release treating agent constituting the release treated layer is not particularly limited. Examples thereof can include a silicone-based release treating agent, a fluorine-based release treating agent, and a long chain alkyl-based release treating agent. These release treating agents can be used alone or in combination of two or more.

The thickness, the forming method, or the like of the release liner is not particularly limited.

The flame-retardant thermally-conductive pressure-sensitive adhesive sheet of the present invention has excellent thermally conductive properties and flame retardancy and has excellent bonding properties to an adherend. The flame-retardant thermally-conductive pressure-sensitive adhesive sheet uses its properties and is capable of being preferably used in uses such as a hard disk, an LED lighting, or a lithium ion battery.

### Examples

In the following, the present invention will now be described in more detail by way of Examples and Comparative Examples. However, the present invention is not limited to the following Examples and Comparative Examples.

### (Example 1)

After 0.05 parts by weight of trade name: "IRGACURE-651" (2,2-dimethoxy-1,2-diphenylethane-1-one, manufactured by BASF Japan Ltd.) and 0.05 parts by weight of trade name: "IRGACURE-184" (1-hydroxycyclohexyl phenyl ketone, manufactured by BASF Japan Ltd.), as photopolymerization initiators, were blended into a monomer mixture in which 82 parts by weight of a 2-ethylhexyl acrylate and 12 parts by weight of a 2-methoxyethyl acrylate, as monomer components, and 5 parts by weight of N-vinyl-2-pyrrolidone (NVP) and 1 part by weight of hydroxyethyl acrylamide (HEAA), as polar group-containing monomers, were mixed, an ultraviolet ray was applied to the obtained mixture until the viscosity (a BH viscometer, a No. 5 rotor, 10 rpm, a measurement temperature of 30°C) thereof reached about 20 Pa·s, so that a composition (a syrup) in which a part of the components was polymerized was fabricated.

0.05 parts by weight of dipentaerythritol hexaacrylate (trade name: "KAYARAD DPHA-40H", manufactured by NIPPON KAYAKU Co., Ltd.) as a polyfunctional monomer and 1 part by weight of trade name: "PLYSURF A212E" (manufactured by DAI-ICHI KOGYO SEIYAKU CO., LTD.) as a dispersant were added to 100 parts by weight of the syrup. In addition, as hydrated metal compounds, 175 parts by weight of trade name: "HIGILITE H-32" (shape: a pulverized shape, particle size: 8 µm, manufactured by SHOWA DENKO K.K.), which was aluminum hydroxide powders, and 175 parts by weight of trade name: "HIGILITE H-10" (shape: a pulverized shape, particle size: 55 µm) (manufactured by SHOWA DENKO K.K.), which was aluminum hydroxide powders, were added to the obtained mixture, so that a precursor composition was fabricated.

The precursor composition was applied between release treated surfaces of two pieces of release liners (trade name: "DIAFOIL MRF38" (manufactured by Mitsubishi Polyester Film GmbH)) made of polyethylene terephthalate, each of which had one surface subjected to release treatment so that the thickness thereof after being dried and cured was 54 µm. That is, the precursor composition was sandwiched between the release liners made of polyethylene terephthalate. Then, an ultraviolet ray at an illuminance of about 5 mW/cm² was applied to the obtained product from both sides thereof for 3 minutes, so that the monomer component was polymerized to serve as an acrylic polymer and in this way, a flame-retardant thermally-conductive pressure-sensitive adhesive layer was fabricated. The acrylic polymer had a glass transition temperature of -62.8°C.

The release liner on the one surface of the flame-retardant thermally-conductive pressure-sensitive adhesive layer was peeled off and the flame-retardant thermally-conductive pressure-sensitive adhesive layer was bonded to both surfaces of a polyethylene terephthalate film (trade name: "Lumirror S-10" (manufactured by TORAY INDUSTRIES, INC.)) having a thickness of 12 µm, so that a flame-retardant thermally-conductive pressure-sensitive adhesive sheet including the polyethylene terephthalate film and the flame-retardant thermally-conductive pressure-sensitive adhesive layers provided on the both surfaces thereof and having a total thickness (excluding the thickness of the release liner, that is, a thickness of 12 µm of the polyethylene terephthalate film and a thickness of 54 µm of each of the flame-retardant thermally-conductive pressure-sensitive adhesive layers, hereinafter the same) of 120 µm was fabricated.

### (Example 2)

A flame-retardant thermally-conductive pressure-sensitive adhesive sheet having a total thickness of 250 µm was fabricated in the same manner as in Example 1, except that in Example 1, the thickness of the flame-retardant thermally-conductive pressure-sensitive adhesive layer was changed to 119 µm.

### (Example 3)

A flame-retardant thermally-conductive pressure-sensitive adhesive sheet having a total thickness of 500 µm was fabricated in the same manner as in Example 1, except that in Example 1, the thickness of the flame-retardant thermally-conductivepressure-sensitive adhesive layer was changed to 244 µm.

### (Example 4)

A flame-retardant thermally-conductive pressure-sensitive adhesive sheet having a total thickness of 120 µm was fabricated in the same manner as in Example 1, except that in Example 1, the thickness of the flame-retardant thermally-conductive pressure-sensitive adhesive layer was changed to 47.5 µm and a polyethylene terephthalate film (trade name: "Lumirror S-10" (manufactured by TORAY INDUSTRIES, INC.)) having a thickness of 25 µm was used as the substrate.

### (Example 5)

A flame-retardant thermally-conductive pressure-sensitive adhesive sheet having a total thickness of 250 µm was fabricated in the same manner as in Example 1, except that in Example 1, the thickness of the flame-retardant thermally-conductive pressure-sensitive adhesive layer was changed to 112.5 µm and a polyethylene terephthalate film (trade name: "Lumirror S-10" (manufactured by TORAY INDUSTRIES, INC.)) having a thickness of 25 µm was used as the substrate.

### (Example 6)

A flame-retardant thermally-conductive pressure-sensitive adhesive sheet having a total thickness of 500 µm was fabricated in the same manner as in Example 1, except that in Example 1, the thickness of the flame-retardant thermally-conductive pressure-sensitive adhesive layer was changed to 237.5 µm and a polyethylene terephthalate film (trade name: "Lumirror S-10" (manufactured by TORAY INDUSTRIES, INC.)) having a thickness of 25 µm was used as the substrate.

### (Example 7)

A flame-retardant thermally-conductive pressure-sensitive adhesive sheet having a total thickness of 120 µm was fabricated in the same manner as in Example 1, except that in Example 1, the thickness of the flame-retardant thermally-conductive pressure-sensitive adhesive layer was changed to 41 µm and a polyethylene terephthalate film (trade name: "Lumirror S-10" (manufactured by TORAY INDUSTRIES, INC.)) having a thickness of 38 µm was used as the substrate.

### (Example 8)

A flame-retardant thermally-conductive pressure-sensitive adhesive sheet having a total thickness of 250 µm was fabricated in the same manner as in Example 1, except that in Example 1, the thickness of the flame-retardant thermally-conductive pressure-sensitive adhesive layer was changed to 106 µm and a polyethylene terephthalate film (trade name: "Lumirror S-10" (manufactured by TORAY INDUSTRIES, INC.)) having a thickness of 38 µm was used as the substrate.

### (Comparative Example 1)

A flame-retardant thermally-conductive pressure-sensitive adhesive sheet having a total thickness of 120 µm was fabricated in the same manner as in Example 1, except that in Example 1, the thickness of the flame-retardant thermally-conductive pressure-sensitive adhesive layer was changed to 59 µm and a polyethylene terephthalate film (trade name: "Lumirror 2DC-61" (manufactured by TORAY INDUSTRIES, INC.)) having a thickness of 2 µm was used as the substrate.

### (Comparative Example 2)

A flame-retardant thermally-conductive pressure-sensitive adhesive sheet having a total thickness of 250 µm was fabricated in the same manner as in Example 1, except that in Example 1, the thickness of the flame-retardant thermally-conductive pressure-sensitive adhesive layer was changed to 124 µm and a polyethylene terephthalate film (trade name: "Lumirror 2DC-61" (manufactured by TORAY INDUSTRIES, INC.)) having a thickness of 2 µm was used as the substrate.

### (Comparative Example 3)

A flame-retardant thermally-conductive pressure-sensitive adhesive sheet having a total thickness of 500 µm was fabricated in the same manner as in Example 1, except that in Example 1, the thickness of the flame-retardant thermally-conductive pressure-sensitive adhesive layer was changed to 249 µm and a polyethylene terephthalate film (trade name: "Lumirror 2DC-61" (manufactured by TORAY INDUSTRIES, INC.)) having a thickness of 2 µm was used as the substrate.

### (Comparative Example 4)

A flame-retardant thermally-conductive pressure-sensitive adhesive sheet having a total thickness of 500 µm was fabricated in the same manner as in Example 1, except that in Example 1, the thickness of the flame-retardant thermally-conductive pressure-sensitive adhesive layer was changed to 231 µm and a polyethylene terephthalate film (trade name: "Lumirror S-10" (manufactured by TORAY INDUSTRIES, INC.)) having a thickness of 38 µm was used as the substrate.

### (Comparative Example 5)

A flame-retardant thermally-conductive pressure-sensitive adhesive sheet having a total thickness of 250 µm was fabricated in the same manner as in Example 1, except that in Example 1, the thickness of the flame-retardant thermally-conductive pressure-sensitive adhesive layer was changed to 100 µm and a polyethylene terephthalate film (trade name: "Lumirror S-10" (manufactured by TORAY INDUSTRIES, INC.)) having a thickness of 50 µm was used as the substrate.

### (Test Evaluation)

The following tests of the flame-retardant thermally-conductive pressure-sensitive adhesive sheets obtained in Examples and Comparative Examples were performed. The test results are shown in Table 1.

### (Thermal Resistance)

The measurement of the thermal resistance was performed using a thermal property evaluation apparatus shown in FIG. 2.

To be specific, each of flame-retardant thermally-conductive pressure-sensitive adhesive sheets S (20 mm × 20 mm) in Examples and Comparative Examples was sandwiched between one pair of blocks (may be referred to as rods) L, each of which was made of aluminum (A5052, thermal conductivity: 140 W/m·K) and was formed to be a cube having one side of 20 mm, and the one pair of blocks L were bonded to each other via the adhesive sheet.

Then, the one pair of blocks L were disposed up and down between a heating element (heater block) H and a heat dissipating element (a cooling base board composed so that cooling water circulated inside thereof) C. To be specific, the heating element H was disposed on the upper-side block L and the heat dissipating element C was disposed below the lower-side block L.

At this time, the one pair of blocks L bonded to each other by the flame-retardant thermally-conductive pressure-sensitive adhesive sheet S were positioned between one pair of pressure adjusting screws T that penetrated through the heating element H and the heat dissipating element C. Load cells R were disposed between the pressure adjusting screws T and the heating element H. The structure was made so as to measure a pressure at the time of allowing the pressure adjusting screws T to be tightened and the obtained pressure was used as a pressure applied to the flame-retardant thermally-conductive pressure-sensitive adhesive sheet S.

Three probes P (a diameter of 1. mm), which were a contact displacement meter, were provided so as to penetrate through the lower-side block L and the flame-retardant thermally-conductive pressure-sensitive adhesive sheet S from the side of the heat dissipating element C. At this time, the upper end portions of the probes P were in a state of being in contact with the lower surface of the upper-side block L. The structure was made so as to be capable of measuring a gap between the upper-side block L and the lower-side block L (the thickness of an adhesive sheet S).

Temperature sensors D were put in the heating element H and the upper-side and lower-side blocks L. To be specific, the temperature sensors D were put in one place in the heating element H and were put in five places with intervals of 5 mm in the up-down direction of each of the blocks L.

In the measurement, first, the pressure adjusting screws T were tightened to apply a pressure to the flame-retardant thermally-conductive pressure-sensitive adhesive sheet S and the temperature of the heating element H was set to be 80°C, while cooling water at 20°C was circulated in the heat dissipating element C.

After the temperature of the heating element H and the upper-side and lower-side blocks L was stabilized, the temperature of the upper-side and lower-side blocks L was measured with the temperature sensors D. The heat flux passing through the flame-retardant thermally-conductive pressure-sensitive adhesive sheet S was calculated from the thermal conductivity (W/m·K) and the temperature gradient of the upper-side and lower-side blocks L, and the temperature at the interfacial surfaces of the upper-side and lower-side blocks L with the flame-retardant thermally-conductive pressure-sensitive adhesive sheet S was calculated. Using the obtained values, the thermal conductivity (W/m·K) and the thermal resistance (cm²·K/W) at the pressure were calculated by using the following heat conduction equation (the Fourier's law).

Q = -λgradT
Q: heat flux per unit area
gradT: temperature gradient
L: thickness of sheet
λ: thermal conductivity
R: thermal resistance

At this time, the thermal conductivity (described later) and the thermal resistance at a pressure of 25 N/cm² (250 kPa) applied to the flame-retardant thermally-conductive pressure-sensitive adhesive sheet S were used.

### (Thermally Conductive Properties)

The measurement of the thermally conductive properties was performed using a thermal property evaluation apparatus that was described above and shown in FIG. 2.

Each of the flame-retardant thermally-conductive pressure-sensitive adhesive sheets S (20 mm × 20 mm) in Examples and Comparative Examples was loaded on an evaluation apparatus in the same manner as that of the measurement of the thermal resistance.

In the measurement, first, the pressure adjusting screws T were tightened and the flame-retardant thermally-conductive pressure-sensitive adhesive sheet S was sandwiched between the upper-side and lower-side blocks to apply a pressure of 25 N/cm² (250 kPa) to the flame-retardant thermally-conductive pressure-sensitive adhesive sheet S, and the heating value of the heating element H was set to be constant at 30 W, while cooling water at 20°C was circulated in the heat dissipating element C. At this time, a case where the temperature change of a thermocouple was 0.02°C or less for 30 seconds was considered to be a stable state and the temperature of the thermocouple that was the side of the heater closest to the sheet was read as a module temperature.

### (Tensile Elastic Modulus)

Each of the flame-retardant thermally-conductive pressure-sensitive adhesive sheets in Examples and Comparative Examples was cut as an evaluation sample so that the initial length in the longitudinal direction was 20 mm, the initial width was 10 mm, and the cross section (the cross section along the thickness direction and the longitudinal direction) was 1.2 to 5.0 mm² (that is, in Examples 1, 4, and 7 and Comparative Example 1, 0.12 mm × 10 mm = 1.2 mm²; in Examples 2, 5, and 8 and Comparative Examples 2 and 5, 0.25 mm × 10 mm = 2.5 mm²; and Examples 3 and 6 and Comparative Examples 3 and 4, 0.50 mm × 10 mm = 5.0 mm²). Next, a tensile test was performed at a measurement temperature of 23°C, a distance between chucks of 20 mm, and a tensile rate of 300 mm/min and an amount of change (mm) of the elongation of the evaluation sample was measured. As a result, a tangential line was drawn on an initial rising part of an obtained S-S curved line and the tensile strength at the time when the tangential line corresponded to 100 % elongation was divided by the cross section of the evaluation sample, so that the obtained value was defined as a tensile elastic modulus.

### (Flame Retardancy)

Each of the flame-retardant thermally-conductive pressure-sensitive adhesive sheets fabricated in Examples and Comparative Examples was cut into pieces each having a size of 12.7 mm × 127 mm and the release films on both surfaces thereof were peeled off to produce five test pieces in each Examples and Comparative Examples. One end of the test piece was vertically held to be suspended. A free end thereof was first subjected to a flame of a burner for 10 seconds; then was released therefrom, and thereafter, was further subjected thereto for 10 seconds. The success or failure in UL94 V-0 of each of the obtained sheets was evaluated in accordance with the following evaluation criteria.
(1) The total flame conbustion time (the total of a burning time after being subjected to a first flame and a burning time after being subjected to a second flame) of each of the test pieces is within 10 seconds.
(2) The total of the total flame conbustion time of the five test pieces is within 50 seconds.
(3) The flame combustion time and the flameless combustion time of each of the test pieces after being subjected to the second flame are within 30 seconds.
(4) When a burning drip falls from the test piece, it fails to ignite a cotton that is disposed below.
(5) Suspended portions fail to burn out in all of the test pieces.

Good: there are 5 or more evaluation criteria satisfying the above-described (1) to (5).

Bad: there are less than 5 evaluation criteria satisfying the above-described (1) to (5).

[Table 1]

**Table 1**

| | | Ex. 1 | Ex. 2 | Ex. 3 | Ex. 4 | Ex. 5 | Ex. 6 | Ex. 7 | Ex. 8 | Comp. Ex. 1 | Comp. Ex 2 | Comp. Ex 3 | Comp. Ex. 4 | Comp. Ex 5 |
|---|---|---|---|---|---|---|---|---|---|---|---|---|---|---|
| Thickness of Substrate | [µm] | 12 | 12 | 12 | 25 | 25 | 25 | 38 | 38 | 2 | 2 | 2 | 38 | 50 |
| Thickness of Flame-Retardant Thermally-Conductive Pressure-Sensitive Adhesive Layer | [µm] | 54 | 119 | 244 | 47.5 | 112.5 | 237.5 | 41 | 106 | 59 | 124 | 249 | 231 | 100 |
| Total Thickness of Sheet *1 | [µm] | 120 | 250 | 500 | 120 | 250 | 500 | 120 | 250 | 120 | 250 | 500 | 500 | 250 |
| Thermal Resistance | [cm²K/W] | 2.0 | 4.2 | 8.3 | 2.1 | 4.4 | 8.8 | 2.7 | 5.6 | 1.6 | 3.5 | 6.8 | 11.1 | 7.3 |
| Thermally Conductive Module Temperature | [°C] | 53.5 | 62.5 | 72.0 | 544 | 63.5 | 74.2 | 56.4 | 67.0 | 51.5 | 60.3 | 69.5 | 80.1 | 70.5 |
| Tensile Elastic Modulus | [MPa] | 56.3 | 62.5 | 68.8 | 165 | 184 | 202 | 358 | 398 | 11.2 | 14 | 21.1 | 438 | 640 |
| Flame Retardancy | UL94 V-0 | Good | Good | Good | Good | Good | Good | Good | Good | Bad | Bad | Bad | Good | Bad |

| | | | | | | | | | | | | | | |
|---|---|---|---|---|---|---|---|---|---|---|---|---|---|---|
| *1 Excluding the thickness of the release liner | | | | | | | | | | | | | | |

As clear from Table 1, each of the flame-retardant thermally-conductive pressure-sensitive adhesive sheets in Examples 1 to 8 uses a polyester film having a thickness of 10 to 40 µm as a substrate and has high flame retardancy (UL94 V-0). The thermal resistance thereof is 10 cm²·K/W or less, so that it is clear that the thermally conductive properties thereof are also high.

On the other hand, in Comparative Examples 1 to 3, a polyester film having a thickness of less than 10 µm is used as a substrate and a flame retardant standard of UL94 V-0 is not satisfied. In Comparative Example 4, the thermal resistance is 10 cm²·K/W or more, so that the thermally conductive properties are poor and the flame-retardant thermally-conductive pressure-sensitive adhesive sheet does not sufficiently function as a thermally conductive sheet. In Comparative Example 5, a polyester film having a thickness of above 40 µm is used as a substrate and the flame retardant standard of UL94 V-0 is not satisfied.

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

### Industrial Applicability

The flame-retardant thermally-conductive pressure-sensitive adhesive sheet of the present invention is used for uses such as a hard disk, an LED lighting, or a lithium ion battery.

## Claims

1. A flame-retardant thermally-conductive pressure-sensitive adhesive sheet comprising:
a substrate and a flame-retardant thermally-conductive pressure-sensitive adhesive layer provided on at least one surface of the substrate, wherein
the substrate includes a polyester film and the thickness of the polyester film is 10 to 40 µm, and
the thermal resistance is 10 cm²·K/W or less.

2. The flame-retardant thermally-conductive pressure-sensitive adhesive sheet according to claim 1, wherein
the flame-retardant thermally-conductive pressure-sensitive adhesive layer does not substantially contain a halogen-based flame-retardant component.

3. The flame-retardant thermally-conductive pressure-sensitive adhesive sheet according to claim 1, wherein
the thickness of the flame-retardant thermally-conductive pressure-sensitive adhesive layer is 10 to 250 µm.

4. The flame-retardant thermally-conductive pressure-sensitive adhesive sheet according to claim 1, wherein
the flame-retardant thermally-conductive pressure-sensitive adhesive layer contains 100 parts by weight of (a) an acrylic polymer and 100 to 500 parts by weight of (b) a hydrated metal compound.

5. The flame-retardant thermally-conductive pressure-sensitive adhesive sheet according to claim 4, wherein
the (a) an acrylic polymer contains, as a polar group-containing monomer, a nitrogen-containing monomer and/or a hydroxyl group-containing monomer as a component.

6. The flame-retardant thermally-conductive pressure-sensitive adhesive sheet according to claim 1, wherein
the flame-retardant thermally-conductive pressure-sensitive adhesive layer contains, as the (b) a hydrated metal compound, a particle having a primary average particle size of 5 µm or more and a particle having a primary average particle size of less than 5 µm at a ratio of 1:10 to 10:1 (ratio by weight).

7. The flame-retardant thermally-conductive pressure-sensitive adhesive sheet according to claim 1, wherein
the tensile elastic modulus is 10 to 600 MPa.
